# EUROPÄISCHE PATENTSCHRIFT

(11) **EP 1 364 373 B1**
(45) Veröffentlichungstag und Bekanntmachung des Hinweises auf die Patenterteilung: **28.12.2005**
(21) Anmeldenummer: 02706677.8
(22) Anmeldetag: 06.02.2002
(51) Int. Cl.: G11C 15/00

(54) **VERFAHREN ZUR HERSTELLUNG EINES SPEICHERKONDENSATORS**
METHOD FOR PRODUCTION OF A MEMORY CAPACITOR
PROCEDE DE PRODUCTION D'UN CONDENSATEUR DE MEMOIRE

(30) Priorität: 26.02.2001 DE 10109218
(43) Veröffentlichungstag der Anmeldung: 26.11.2003
(73) Patentinhaber: Infineon Technologies AG, 81669 München (DE)
(72) Erfinder: SELL, Bernhard, Portland, OR 97210 (US); SÄNGER, Annette, 01099 Dresden (DE); SCHUMANN, Dirk, 16567 Schönfliess (DE)
(74) Vertreter: Epping - Hermann - Fischer
(86) Internationale Anmeldenummer: PCT/DE2002/000436
(87) Internationale Veröffentlichungsnummer: WO 2002/069345

(56) Entgegenhaltungen:
- EP-A- 0 967 643
- EP-A- 0 981 164
- WO-A-01/20681
- US-A- 4 589 193
- US-A- 5 262 343
- PATENT ABSTRACTS OF JAPAN vol. 012, no. 285 (E-642), 4. August 1988 (1988-08-04) & JP 63 062371 A (MITSUBISHI ELECTRIC CORP), 18. März 1988 (1988-03-18)

## Beschreibung

Die vorliegende Erfindung betrifft ein Verfahren zur Herstellung eines Speicherkondensators zur Verwendung in einer DRAM-Speicherzelle, bei dem die untere Kondensatorelektrode als metallische Elektrode ausgeführt wird.

In Speicherzellenanordnungen mit dynamischem, wahlfreien Zugriff werden fast ausschließlich sogenannte Eintransistor-Speicherzellen eingesetzt. Eine Eintransistor-Speicherzelle umfaßt einen Auslesetransistor und einen Speicherkondensator. In dem Speicherkondensator ist die Information in Form einer elektrischen Ladung gespeichert, die eine logische Größe, 0 oder 1, darstellt. Durch Ansteuerung des Auslesetransistors über eine Wortleitung kann diese Information über eine Bitleitung ausgelesen werden. Zur sicheren Speicherung der Ladung und gleichzeitigen Unterscheidbarkeit der ausgelesenen Information muß der Speicherkondensator eine Mindestkapazität aufweisen. Die untere Grenze für die Kapazität des Speicherkondensators wird derzeit bei 25 fF gesehen.

Da von Speichergeneration zu Speichergeneration die Speicherdichte zunimmt, muß die benötigte Fläche der Eintransistor-Speicherzelle von Generation zu Generation reduziert werden. Gleichzeitig muß die Mindestkapazität des Speicherkondensators erhalten bleiben.

Bis zur 1 Mbit-Generation wurden sowohl der Auslesetransistor als auch der Speicherkondensator als planare Bauelemente realisiert. Ab der 4 Mbit-Speichergeneration wurde eine weitere Flächenreduzierung der Speicherzelle durch eine dreidimensionale Anordnung von Auslesetransistor und Speicherkondensator erzielt. Eine Möglichkeit besteht darin, den Speicherkondensator in einem Graben zu realisieren (siehe z.B. K. Yamada et al., Proc. Intern. Electronic Devices and Materials IEDM 85, S. 702 ff). Als Elektroden des Speicherkondensators wirken in diesem Fall ein an die Wand des Grabens angrenzendes Diffusionsgebiet sowie eine dotierte Polysiliziumfüllung, die sich im Graben befindet. Die Elektroden des Speicherkondensators sind somit entlang der Oberfläche des Grabens angeordnet. Dadurch wird die effektive Fläche des Speicherkondensators, von der die Kapazität abhängt, gegenüber dem Platzbedarf für den Speicherkondensator an der Oberfläche des Substrats, der dem Querschnitt des Grabens entspricht, vergrößert. Durch Reduktion des Querschnitts des Grabens läßt sich die Packungsdichte weiter erhöhen. Der Vergrößerung der Tiefe des Grabens sind dabei aus technologischen Gründen jedoch Grenzen gesetzt.

Bei einem alternativen Kondensatorkonzept wird der Speicherkondensator als Stapel auf dem Auswahltransistor gebildet.

Aus der US-A-5,760,434 ist ein Verfahren zur Herstellung einer DRAM-Speicherzelle mit einem Stapelkondensator bekannt, bei dem nach Bildung des Auswahltransistors und Erzeugen einer Polysilizium-Verbindungsstruktur zu den aktiven Bereichen des Transistors die sich ergebende Oberfläche mit beispielsweise BPSG planarisiert wird und sodann Kontaktlöcher bis zu den Verbindungsstrukturen geätzt werden. Anschließend wird auf der gesamten Oberfläche, also auch außerhalb der Kontaktlöcher, Polysilizium und nachfolgend beispielsweise Wolfram abgeschieden. Durch einen darauf folgenden Temperaturbehandlungsschritt wird die Silizidbildung verursacht. Anschließend wird das nicht umgesetzte Metall durch einen selektiven Ätzprozeß entfernt. Das außerhalb der Kontaktlöcher gebildete Wolframsilizid wird später durch chemisch-mechanisches Polieren entfernt.

In der US-A-5,262,343 wird ein Verfahren zur Herstellung eines Stapelkondensators beschrieben, bei dem zunächst eine Polysiliziumschicht photolithographisch strukturiert wird und nach Entfernen des Photoresistmaterials ein Metall wie beispielsweise Platin, Chrom, Kobalt oder andere auf dem Polysilizium abgeschieden und zur Metallsilizidbildung anschließend einer Temperaturbehandlung unterzogen wird.

Aus der US-A-5,905,279 ist eine Speicherzelle mit einem in einem Graben angeordneten Speicherkondensator und einem Auswahltransistor bekannt, bei dem der Speicherkondensator eine an eine Wand des Grabens angrenzende untere Kondensatorelektrode, ein Kondensatordielektrikum und eine obere Kondensatorelektrode aufweist und die obere Kondensatorelektrode eine leitende Schicht, insbesondere aus WSi, TiSi, W, Ti oder TiN, umfaßt.

In der EP-A-0 495 991 wird ein Verfahren zur Herstellung eines ferroelektrischen Speichers beschrieben, bei dem der ferroelektrische Kondensator als planarer Kondensator ausgeführt ist. Gemäß einer bevorzugten Ausführungsform ist die untere Kondensatorelektrode PtSi oder TiSi und nur über dem Kontaktloch über dem Source-Bereich gebildet.

Ein Verfahren zur selbstjustierten Titansilizid-Bildung zur Erzeugung planarer Strukturen wie beispielsweise einer Gate-Elektrode ist überdies aus IEEE Journal Solid-State Circuits, Vol. SC-20, Nr. 1, 1985, Seiten 61 bis 69 bekannt.

In der EP-A-0 967 643 wird ein Verfahren zur Herstellung eines Grabenkondensators beschrieben, bei dem die obere Kondensatorelektrode aus einem Metallsilizid gebildet wird, während die untere Kondensatorelektrode aus dotiertem Silizium hergestellt wird.

In der nachveröffentlichten PCT-Anmeldung WO 01/17014 A1 wird überdies vorgeschlagen, bei einer Speicherzelle mit Auswahltransistor und Grabenkondensator die untere Kondensatorelektrode als metallische Elektrode auszubilden. Die metallische Elektrode wird gebildet, indem in dem Graben, der im oberen Bereich mit einer Siliziumnitrid-Spacerschicht ausgekleidet ist, durch ein CVD-Verfahren ganzflächig Wolframsilizid abgeschieden wird. Darauf folgend wird durch Abscheidung von Photolack in dem Graben der untere Teil des Grabens mit einer Lackfüllung versehen, welche in einem darauf folgenden Schritt zum Ätzen des Wolframsilizids als Ätzmaske dient. Anschließend wird die Photolackfüllung entfernt und der Kondensator und darauf folgend die Speicherzelle in bekannter Weise fertiggestellt.

In der ebenfalls nachveröffentlichten WO 01/20681 wird ein Verfahren zur Herstellung eines Grabenkondensators beschrieben, bei dem die untere Kondensatorelektrode derart ausgebildet wird, daß sie nicht nur im unteren Grabenbereich angeordnet ist, sondern sich auch entlang dem Isolationskragen erstreckt.

Der vorliegenden Erfindung liegt die Aufgabe zugrunde, ein verbessertes Verfahren zur Herstellung eines Speicherkondensator bereitzustellen.

Gemäß der vorliegenden Erfindung wird die Aufgabe durch ein Verfahren zur Herstellung eines Speicherkondensators mit vertikalem Aufbau in Bezug auf eine Hauptfläche eines Substrats, insbesondere zur Verwendung in einer DRAM-Speicherzelle, bei dem eine untere metallische Kondensatorelektrode, ein Speicherdielektrikum und eine obere Kondensatorelektrode in oder auf der Hauptfläche des Substrats gebildet werden, wobei die untere metallische Kondensatorelektrode in der Weise selbstjustiert auf einem Silizium-Grundmaterial gebildet wird, daß zunächst freiliegende Silizium-Bereiche an den Stellen, an denen die untere Kondensatorelektrode zu bilden ist, erzeugt werden und sodann auf den freiliegenden Silizium-Bereichen Metallsilizid selektiv gebildet wird, und der Schritt der selektiven Bildung von Metallsilizid auf den freiliegenden Siliziumbereichen den Schritt zur selektiven Abscheidung des Metallsilizids auf den freiliegenden Siliziumbereichen aus der Gasphase umfaßt, gelöst.

Insbesondere wird die Aufgabe durch ein Verfahren zur Herstellung einer Speicherzelle mit einem Speicherkondensator, der als Grabenkondensator ausgeführt ist, und einem Auswahltransistor, mit den Schritten zum Ätzen eines Grabens in eine Hauptfläche eines Halbleitersubstrats, zum Durchführen des vorstehend beschriebenen Verfahrens, wobei der Speicherkondensator zumindest teilweise in dem Graben angeordnet wird und die untere metallische Kondensatorelektrode an eine Wand des Grabens angrenzt, und zum Bilden des Auswahltransistors mit Source-Elektrode, Drain-Elektrode, leitendem Kanal und Gate-Elektrode, wobei die obere Kondensatorelektrode mit der Source- oder Drain-Elektrode des Auswahltransistors elektrisch leitend verbunden wird, gelöst.

Ferner wird die Aufgabe durch ein Verfahren zur Herstellung einer Speicherzelle mit einem Speicherkondensator, der als Stapelkondensator ausgeführt ist, und einem Auswahltransistor, mit dem Schritt zum Bilden eines Auswahltransistors mit Source-Elektrode, Drain-Elektrode, leitendem Kanal und Gate-Elektrode auf einer Hauptfläche eines Halbleitersubstrats, den Schritten des vorstehend beschriebenen Verfahrens, so daß die untere Kondensatorelektrode auf einer elektrisch leitenden Verbindungsstruktur aus Polysilizium, die die untere Kondensatorelektrode mit der Source- oder Drain-Elektrode des Auswahltransistors verbindet, auf der sich ergebenden Oberfläche gebildet wird, gelöst.

Dabei ist ein Speicherkondensator mit vertikalem Aufbau in Bezug auf eine Hauptfläche eines Substrats im wesentlichen ein nicht-planarer Kondensator, beispielsweise ein Grabenkondensator oder ein Stapelkondensator. Genauer gesagt, hat ein derartiger Kondensator Elektroden, die sich nicht ausschließlich parallel zur Substratoberfläche erstrecken sondern die auch Komponenten senkrecht zur Substratoberfläche aufweisen. Insbesondere weist die untere Kondensatorelektrode eine vertikale Komponente auf. Das Verhältnis von senkrechter Komponente zu paralleler Komponente nimmt dabei Werte größer als 1 an.

Typischerweise haben Grabenkondensatoren ein Aspektverhältnis von Tiefe (senkrechter Komponente) zu Breite (paralleler Komponente) zwischen 20:1 bis etwa 60:1. Stapelkondensatoren weisen typischerweise ein Aspektverhältnis von 5:1 bis 20:1 auf.

Die Aufgabe wird auch durch ein Verfahren zur Herstellung eines Grabenkondensators, insbesondere zur Verwendung in einer DRAM-Speicherzelle, gelöst mit den Schritten: Ätzen eines Grabens in eine Hauptfläche eines Siliziumsubstrats, Erzeugen freiliegender Siliziumbereiche durch Aufbringen eines Abdeckmaterials auf den Grabenbereichen, auf denen die untere Kondensatorelektrode nicht zu bilden ist, selbstjustierte Bildung der unteren metallischen Kondensatorelektrode durch selektive Bildung von Metallsilizid auf den freiliegenden Silizium-Bereichen, wobei der Speicherkondensator zumindest teilweise in dem Graben angeordnet wird und die untere metallische Kondensatorelektrode an eine Wand des Grabens angrenzt, nachfolgendes Bilden eines Speicherdielektrikums und anschließendes Bilden einer oberen Kondensatorelektrode.

Das erfindungsgemäße Verfahren zur Herstellung eines Speicherkondensators beruht im wesentlichen darauf, daß die untere Kondensatorelektrode des Speicherkondensators selbstjustiert gebildet wird. Genauer gesagt, wird bei dem erfindungsgemäßen Verfahren die untere Kondensatorelektrode aus einem Metallsilizid selektiv auf freiliegenden Silizium-Bereichen gebildet. Der Ausdruck "freiliegende Silizium-Bereiche" umfaßt dabei alle Arten von Silizium, insbesondere einkristallines Silizium und polykristallines Silizium (Polysilizium) aber auch beispielsweise amorphes Silizium. Freiliegende Silizium-Bereiche können gemäß der vorliegenden Erfindung insbesondere dadurch erzeugt werden, daß auf einem Silizium-Grundmaterial die Bereiche, auf denen die untere Kondensatorelektrode nicht gebildet werden soll, mit einem Abdeckmaterial, beispielsweise Si₃N₄ oder SiO₂ oder einer Kombination dieser Material abgedeckt werden. Selbstverständlich sind aber auch andere Abdeckmaterialien denkbar.

Alternativ kann auf einem Nicht-Silizium-Grundmaterial eine strukturierte Polysiliziumschicht aufgebracht werden, beispielsweise, indem Polysilizium zunächst ganzflächig aufgebracht wird und anschließend an den Stellen, an denen die untere Kondensatorelektrode nicht gebildet werden soll, beispielsweise durch Ätzen oder chemisch-mechanisches Polieren wieder entfernt wird. Das Nicht-Silizium-Grundmaterial umfaßt alle Materialien außer Silizium, insbesondere außer einkristallinem Silizium, außer Polysilizium oder außer amorphem Silizium. Das Nicht-Silizium-Grundmaterial kann selbst aber durchaus Silizium enthalten, wie beispielsweise Siliziumdioxid oder Siliziumnitrid.

Durch das erfindungsgemäße Verfahren werden folgende Vorteile erzielt:
- Die untere Elektrode des Speicherkondensators wird als eine Metallelektrode realisiert. Da Metall eine höhere Austrittsarbeit als dotiertes Silizium, welches bisher als untere Kondensatorelektrode verwendet wurde, aufweist, werden infolge der erhöhten Tunnelbarriere die Leckströme verringert. Als Folge kann bei vorgegebenem maximalem Leckstrom unter Verwendung einer metallischen Elektrode die Schichtdicke des Dielektrikums reduziert werden, wodurch die Kapazität des Kondensators erhöht wird.
- Ein weiterer Vorteil der Metallelektrode gegenüber einer Kondensatorelektrode aus dotiertem Silizium ist die erhöhte Kapazität der Metallelektrode, da an ihr keine Verarmungszone gebildet wird.
- Die selbstjustierte Bildung der Metallsilizidschicht auf freiliegenden Silizium-Bereichen ist weniger kompliziert als das vorstehend beschriebene Verfahren, bei dem die Metallsilizidschicht ganzflächig aufgebracht und anschließend selektiv geätzt wird. Insbesondere, wenn das Abdeckmaterial zum Abdecken der Siliziumbereiche, auf denen keine Metallsilizidschicht erzeugt werden soll, später als Isolationskragen des Speicherkondensators oder als Diffusionsbarriere wirkt, erfordert die selbstjustierte Bildung der Metallsilizidschicht keine zusätzlichen Prozeßschritte zur Strukturierung.
- Bei dem herkömmlichen Verfahren ist es schwierig sicherzustellen, daß die Metallsilizidschicht im Bereich des Siliziumnitrid-Spacers selektiv entfernt wird, während sie im unteren Bereich des Grabens vollständig verbleibt, so daß kein freiliegendes Silizium in Kontakt mit dem Kondensatordielektrikum steht. Im Gegensatz dazu wird bei einer selbstjustierten Bildung von Metallsilizid gewährleistet, daß sämtliche freiliegende Siliziumbereiche von einer Metallsilizidschicht bedeckt sind. Dies ist sehr wichtig, um Leckströme zu minimieren, da diese über freiliegende Siliziumbereiche, die in Kontakt mit dem Kondensatordielektrikum stehen, fließen würden. Wenn Leckströme minimiert werden, kann umgekehrt wieder die Schichtdicke des Kondensatordielektrikums reduziert werden, wodurch die Kapazität des Kondensators erhöht wird.
- Da bei dem herkömmlichen Verfahren Photolack den unteren Bereich der Gräben auffüllt und anschließend wieder entfernt wird, ergeben sich Probleme bei einer weiteren Strukturverkleinerung. Das erfindungsgemäße Verfahren hingegen ist problemlos auf kleinere Größen skalierbar.
- Das erfindungsgemäße Verfahren ist mit oberflächenvergrößernden Maßnahmen wie beispielsweise dem HSG-Verfahren (Aufrauhung der Siliziumoberfläche, "hemispherical graining") oder Mesoporen-Ätzung kombinierbar.
- Die durch das erfindungsgemäße Verfahren herstellbare Elektrodenanordnung ist temperaturstabil und hält alle nachfolgenden Schritte des derzeit eingesetzten DRAM-Prozesses aus.
- Ein besonderer Vorteil des erfindungsgemäßen Verfahrens besteht darin, dass zur selbstjustierten Bildung des Metallsilizids ein Gasphasenverfahren mit einem metallhaltigen Gas durchgeführt wird. Dabei ist nämlich zur Bildung des Metallsilizids nur ein metallhaltiger Prekursor und kein siliziumhaltiger Prekursor notwendig. Dadurch ergibt sich der Vorteil, daß das Abscheideverhalten von nur einem Prekursor berücksichtigt werden muß, wodurch einerseits die Kantenbedeckung, welche gerade bei der Abscheidung auf einer Struktur mit einem vertikalen Aufbau kritisch ist, andererseits das stöchiometrische Verhältnis der sich ergebender Schicht in gewünschter Weise eingestellt werden kann. Gerade bei Kondensatorgräben mit einem hohen Aspektverhältnis ergibt sich bei herkömmlichen Abscheideverfahren der Nachteil, daß das stöchiometrische Verhältnis der Metallsilizidschicht von der Tiefe des Grabens abhängt. Dieser Nachteil kann durch ein Abscheideverfahren mit nur einem Prekursor vermieden werden.

Gemäß einer Ausführungsform der vorliegenden Erfindung, bei der der Kondensator als Grabenkondensator ausgeführt wird, werden zur Bildung der unteren metallischen Kondensatorelektrode zunächst ausgewählte Bereiche des Grabens, an denen die untere Kondensatorelektrode nicht gebildet werden soll, mit einem Abdeckmaterial, beispielsweise Siliziumnitrid, Siliziumdioxid oder einer Kombination dieser Materialien, bedeckt.

Zweckmäßigerweise wird ein Abdeckmaterial mit einer derartigen Zusammensetzung und in einer derartigen Dicke aufgebracht, daß es später als Isolationskragen des fertigen Speicherkondensators oder als Diffusionsbarriere wirken wird. In diesem Fall wird das Herstellungsverfahren insbesondere vereinfacht, weil keine zusätzlichen Schritte zur Strukturierung des Silizium-Grundmaterials notwendig sind.

Gemäß einer anderen Ausführungsform der vorliegenden Erfindung, bei der der Kondensator als Stapelkondensator ausgeführt wird, wird Polysilizium selektiv nur an den Stellen der Oberfläche aufgebracht, an denen später auch die untere Kondensatorelektrode hergestellt werden soll. Auch in diesem Fall wird das Herstellungsverfahren dadurch vereinfacht, daß keine zusätzlichen Schritte zur Strukturierung des Silizium-Grundmaterials notwendig sind.

Sodann wird auf den freiliegenden Siliziumbereichen Metallsilizid selektiv gebildet.

Dies kann beispielsweise durch ein Verfahren erfolgen, das auch als sogenanntes salicide-Verfahren ("self-aligned silicide") bekannt ist. Dazu wird eine Metallschicht, beispielsweise Wolfram, Titan, Tantal, Molybdän, Kobalt, Nickel, Niob-Platin, Palladium oder ein Seltenerdmetall abgeschieden. Nachfolgend wird ein Temperaturbehandlungsschritt, beispielsweise je nach verwendetem Metall in einer Stickstoffatmosphäre bei einer Temperatur von 600 bis 1000°C durchgeführt. Bei diesem Temperaturbehandlungsschritt reagiert das abgeschiedene Metall mit darunterliegendem Silizium zu Metallsilizid, das auf dem Abdeckmaterial abgeschiedene Metall reagiert nicht. In einem darauf folgenden selektiven Ätzschritt wird das nicht umgesetzte Metall weggeätzt und das Metallsilizid verbleibt auf den Siliziumbereichen.

Gemäß einer bevorzugten Ausführungsform der vorliegenden Erfindung kann der Schritt zur Temperaturbehandlung so durchgeführt werden, daß nicht die vollständige Metallschicht durchsilizidiert wird. In diesem Fall wird der Schritt zur Temperaturbehandlung bei einer geeignet niedrigen Temperatur durchgeführt, so daß die Silizidbildung relativ langsam erfolgt, und die Zeitdauer der Temperaturbehandlung wird so eingestellt, daß die Metallschicht nicht vollständig durchsilizidiert wird.

Bei dieser Ausführungsform wird der zusätzliche Vorteil erreicht, daß eine Inhomogenität bei der Metallabscheidung ausgeglichen werden kann, da an den Stellen, an denen das Metall mit einer größeren Schichtdicke abgeschieden wurde, das nicht umgewandelte Metall im nachfolgenden Schritt wieder entfernt wird. Durch diese Maßnahme können vorteilhafterweise sehr dünne Metallelektroden mit minimalen Kapazitätsverlusten realisiert werden.

Die selektive Bildung von Metallsilizid kann aber auch durch eine selektive Metallsilizid-Abscheidung erfolgen. Erfindungsgemäss ist vorgesehen, unter Verwendung eines Gasphasenverfahrens mit einem metallhaltigen Gas, beispielsweise WF₆ , eine selektive Reaktion des metallhaltigen Gases mit dem freiliegenden Silizium herbeizuführen. In diesem Fall wird das freiliegende Silizium an der Oberfläche etwas weggeätzt und geht während des Abscheideverfahrens eine Reaktion mit dem metallhaltigen Gas ein, wobei sich unter anderem eine Metallsilizidschicht bildet.

Herkömmliche Verfahren sehen hingegen vor, daß die Metallsilizidschicht durch ein CVD-Verfahren unter Verwendung eines siliziumhaltigen Gases, beispielsweise SiH₄ oder SiH₂Cl_{2,} und eines metallhaltigen Gases, beispielsweise WF₆, TaCl₅ oder TiCl₄, unter geeigneten Bedingungen selektiv auf den freiliegenden Siliziumbereichen gebildet wird.

Die Verfahren zur selektiven Abscheidung eines Metallsilizids sind dahingehend vorteilhaft, daß kein nachfolgender Schritt zur Temperaturbehandlung notwendig ist. Allerdings müssen die Abscheidebedingungen, insbesondere Druck und Temperatur, sehr genau eingestellt werden, wodurch das Prozeßfenster verkleinert wird und sich die Frage stellt, inwieweit diese Verfahren in der industriellen Chipfertigung einsetzbar sind.

Gemäß der vorliegenden Erfindung kann das Substrat, in dem die Speicherzelle gebildet wird, ein gewöhnliches Siliziumsubstrat oder aber auch ein SOI-Substrat (Silicon on Insulator oder Silizium auf Isolatorsubstrat) sein. Die Verwendung eines SOI-Substrats ist dahingehend vorteilhaft, daß der Verfahrensablauf weiter vereinfacht werden kann, da die vergrabene Siliziumdioxidschicht als Ätzstoppschicht wirkt. Insbesondere muß bei Verwendung eines SOI-Substrats kein ausreichend dicker (ca. 20 nm) Isolationskragen im oberen Grabenbereich abgeschieden werden, wodurch bei Verwendung eines Siliziumsubstrats die Grabenöffnung stark verengt und entsprechend der Verfahrensablauf erschwert wird.

Gemäß der vorliegenden Erfindung kann die effektive Kondensatorfläche und damit die Kapazität des Speicherkondensators dadurch erhöht werden, daß nach dem Schritt zur Erzeugung freiliegender Silizium-Bereiche an diesen Bereichen oberflächenvergrößernde Maßnahmen durchgeführt werden. Beispielsweise können Mesoporen geätzt werden, oder es kann ein Verfahren zur Kristallisation einer zuvor aufgebrachten amorphen Siliziumschicht durch Aufbringen von Kristallisationskeimen und eine nachfolgende Temperaturbehandlung durchgeführt werden. Selbstverständlich kann auch jedes andere Verfahren zur Oberflächenvergrößerung vor Aufbringen der Metallschicht bzw. Metallsilizidschicht durchgeführt werden.

Die vorliegende Erfindung wird im folgenden unter Bezugnahme auf die begleitenden Zeichnungen näher erläutert:
- Figur 1 bis Figur 7: zeigt die Schritte zur Herstellung der unteren Elektrode einer Speicherzelle gemäß einer ersten Ausführungsform der vorliegenden Erfindung;
- Figur 8 bis Figur 14: zeigt die Schritte zur Herstellung der unteren Elektrode einer Speicherzelle gemäß einer zweiten Ausführungsform der vorliegenden Erfindung;

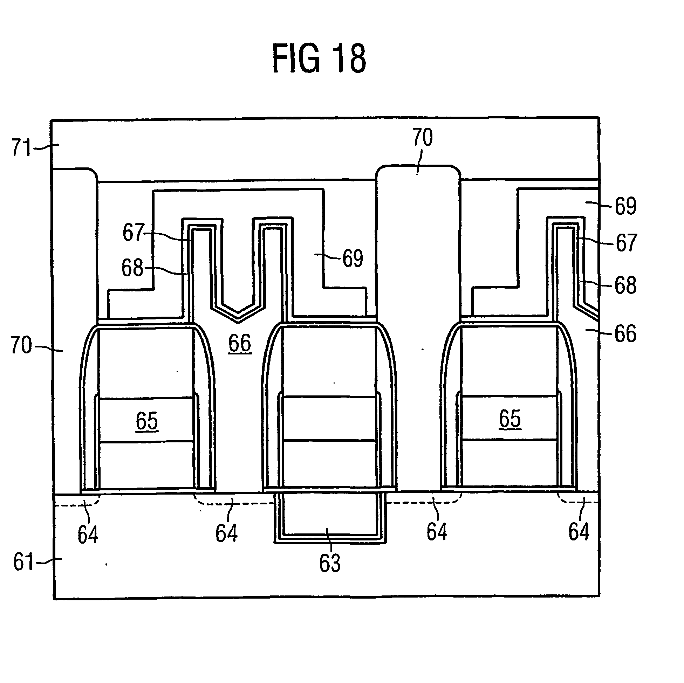

- Figur 15 bis Figur 18: zeigt die Schritte zur Herstellung der unteren Elektrode einer Speicherzelle mit einem Stapolkondensator; und

Figur 19 zeigt das Layout in einer 8F²-Zellarchitektur.

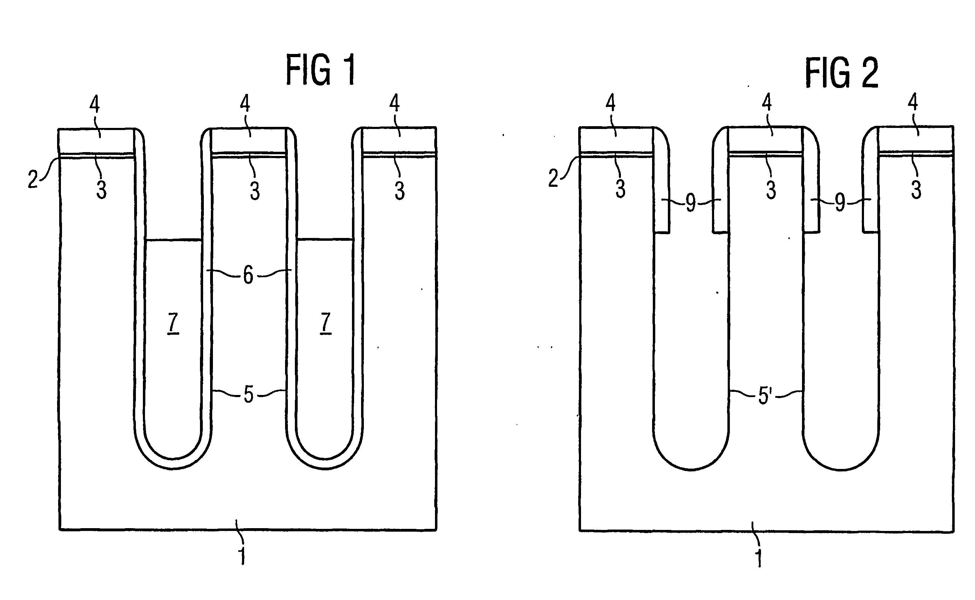

In Figur 1 bezeichnet Bezugszeichen 1 ein Siliziumsubstrat mit einer Hauptfläche 2. Auf der Hauptfläche 2 werden eine 5 nm dicke SiO₂-Schicht 3 und eine 200 nm dicke Si₃N₄-Schicht 4 aufgebracht. Darauf wird eine 1000 nm dicke BSG-Schicht (nicht dargestellt) als Hartmaskenmaterial aufgebracht.

Unter Verwendung einer photolithographisch erzeugten Maske (nicht dargestellt) werden die BSG-Schicht, die Si₃N₄-Schicht 4 und die SiO₂-Schicht 3 in einem Plasma-Ätzprozeß mit CF₄/CHF₃ strukturiert, so daß eine Hartmaske gebildet wird. Nach Entfernung der photolithographisch erzeugten Maske werden unter Verwendung der Hartmaske als Ätzmaske in einem weiteren Plasma-Ätzprozeß mit HBr/NF₃ Gräben 5 in die Hauptfläche 1 geätzt. Nachfolgend wird durch eine nasse Ätzung mit H₂SO₄/HF die BSG-Schicht entfernt.

Die Gräben 5 weisen beispielsweise eine Tiefe von 5 µm, eine Weite von 100 x 250 nm und einen gegenseitigen Abstand von 100 nm auf.

Nachfolgend wird eine 10 nm dicke SiO₂-Schicht 6, die auch, beispielsweise durch in-situ-Dotierung, dotiert sein kann, abgeschieden. Die abgeschiedene SiO₂-Schicht 6 bedeckt mindestens die Wände der Gräben 5. Durch Abscheidung einer 200 nm dicken Polysiliziumschicht, chemisch-mechanisches Polieren bis zur Oberfläche der Si₃N₄-Schicht 4 und Zurizckätzen der Polysiliziumschicht mit SF₆ wird in den Gräben 5 jeweils eine Polysiliziumfüllung 7 erzeugt, deren Oberfläche 1000 nm unterhalb der Hauptfläche 2 angeordnet ist (siehe Figur 1). Das chemisch-mechanische Polieren kann dabei gegebenenfalls entfallen. Die Polysiliziumfüllung 7 dient als Opferschicht für die nachfolgende Si₃N₄-Spacerabscheidung. Darauf folgend wird die SiO₂-Schicht 6 auf den Wänden der Gräben 5 isotrop geätzt.

Anschließend wird in einem CVD-Verfahren eine 20 nm dicke Spacerschicht 9, die Siliziumnitrid- und/oder Siliziumdioxid umfaßt, abgeschieden und in einem anisotropen Plasma-Ätzprozeß mit CHF₃ geätzt. Die soeben abgeschiedene Spacerschicht 9 dient als Abdeckmaterial bei dem Schritt zur selektiven Bildung des Metallsilizids auf freiliegenden Siliziumbereichen. In der fertigen Speicherzelle dient sie zum Abschalten des parasitären Transistors, der sich sonst an dieser Stelle bilden würde, und übernimmt somit die Rolle des Isolationskragens.

Mit SF₆ wird nachfolgend Polysilizium selektiv zu Si₃N₄ und SiO₂ geätzt. Dabei wird die Polysiliziumfüllung 7 jeweils vollständig aus dem Graben 5 entfernt. Durch eine Ätzung mit NH₄F/HF wird der nunmehr freiliegende Teil der SiO₂-Schicht 6 entfernt (siehe Figur 2).

Gegebenenfalls wird nun zur Aufweitung der Gräben 5 in ihrem unteren Bereich, d.h. in dem der Hauptfläche 2 abgewandten Bereich, Silizium selektiv zu der Spacerschicht geätzt. Dies erfolgt beispielsweise durch einen isotropen Ätzschritt mit Ammoniak, bei dem Silizium selektiv zu Si₃N₄ geätzt wird. Die Ätzdauer wird so bemessen, daß 20 nm Silizium geätzt werden. Dadurch wird der Querschnitt im unteren Bereich der Gräben 5 um 40 nm aufgeweitet. Dadurch kann die Kondensatorfläche und damit die Kapazität des Kondensators weiter vergrößert werden.

In den Zeichnungen ist der Prozeßablauf mit nicht aufgeweiteten Gräben veranschaulicht.

Anschließend erfolgt, falls dies nicht schon durch das dotierte Oxid geschehen ist, eine Dotierung des Silizium-Substrats. Dies kann beispielsweise durch Abscheidung einer Arsen-dotierten Silikatglasschicht in einer Schichtdicke von 50 nm und einer TEOS-SiO₂-Schicht in einer Dicke von 20 nm und einen anschließenden Temperaturbehandlungsschritt bei 1000°C, 120 Sekunden, wodurch durch Ausdiffusion aus der Arsen-dotierten Silikatglasschicht in dem Siliziumsubstrat 1 ein n⁺-dotiertes Gebiet 11 gebildet wird, geschehen. Alternativ kann auch eine Gasphasendotierung durchgeführt werden, zum Beispiel mit folgenden Parametern: 900°C, 399 Pa Tributylarsin (TBA) [33 Prozent], 12 min.

Durch das n⁺-dotierte Gebiet wird die Verarmungszone verkleinert, wodurch die Kapazität des Kondensators weiter erhöht wird. Bei Verwendung einer metallischen Bottom-Elektrode dient diese dotierte Schicht zur Herstellung eines ohmschen Kontaktes zwischen Substrat und Metall.

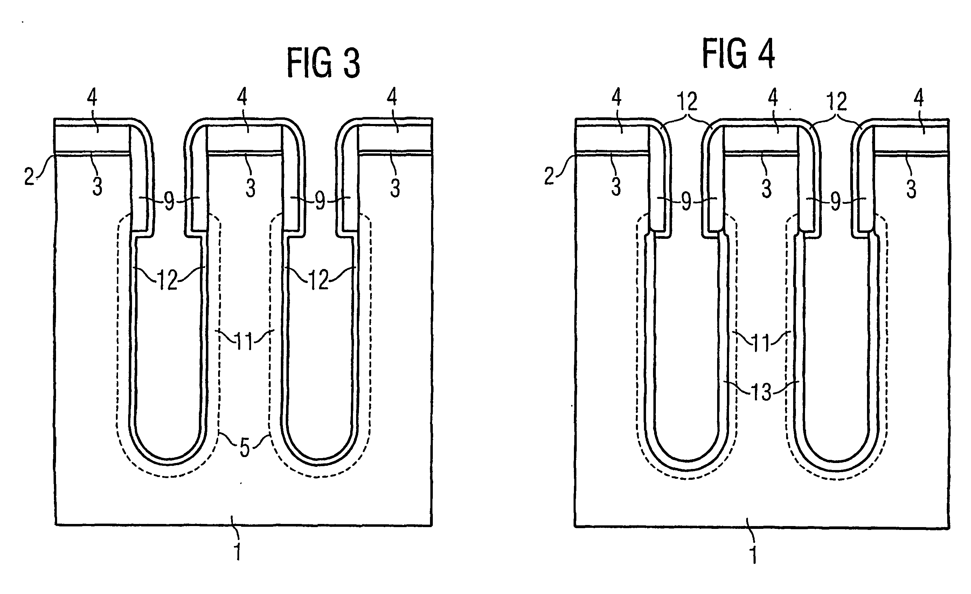

Darauf folgend wird eine 10 nm dicke Wolframschicht 12 beispielsweise durch ein CVD-Verfahren ganzflächig abgeschieden (siehe Figur 3).

In einem nachfolgenden Temperaturbehandlungsschritt bei 600 bis 800°C in einer Stickstoffatmosphäre (N₂-RTP, "Rapid Thermal Annealing") wird das selbstjustierte Wolframsilizid gebildet. Genauer gesagt, bildet sich nur an den Stellen, an denen das Wolfram direkt auf dem Silizium abgeschieden wurde, Wolframsilizid 13, während das Metall, das direkt auf dem Nitrid abgeschieden wurde, nicht mit dem Substrat reagiert. Dies ist in Figur 4 veranschaulicht. Eine geringfügige Aufweitung der Kondensatorgräben ergibt sich bei diesem Schritt dadurch, daß für die Wolframsilizidbildung Silizium an den Wänden der Gräben verbraucht wird.

Gemäß einer bevorzugten Ausführungsform kann dieser Temperaturbehandlungsschritt so eingestellt werden, daß nicht das komplette Wolfram durchsilizidiert wird. Dadurch können, wie vorstehend beschrieben, besonders dünne Metallelektroden realisiert werden. Zusätzlich können Inhomogenitäten in der Schichtdicke des Metalls ausgeglichen werden.

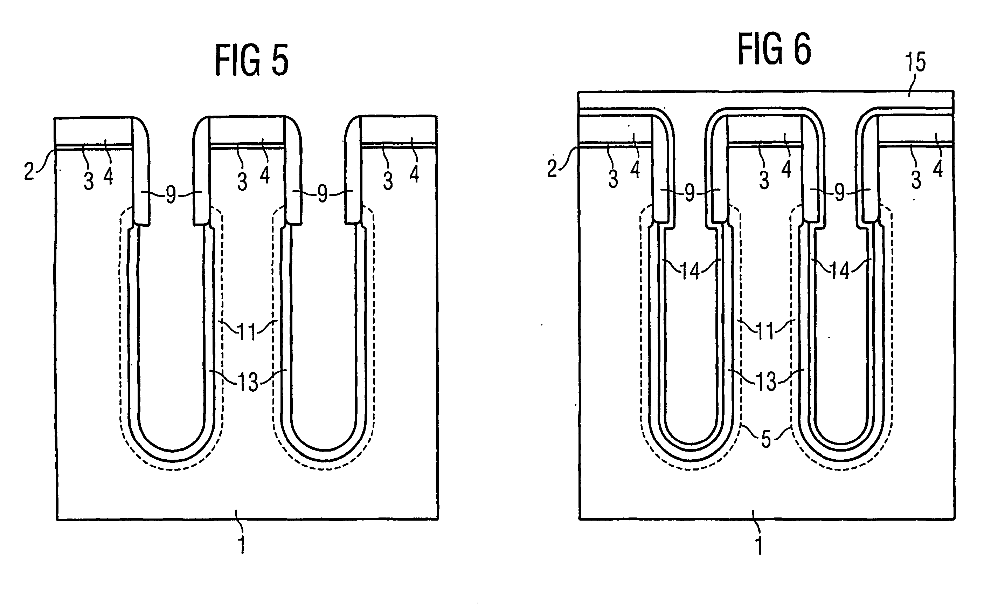

Schließlich wird das Wolfram selektiv zum Wolframsilizid geätzt. Dies kann beispielsweise durch Naßätzen in H₂O/NH₄OH/H₂O₂ erfolgen (siehe Figur 5).

Durch diesen Schritt wird der Teil der Wolframschicht, der auf dem freiliegenden Silizium abgeschieden war und mit diesem während des Temperaturbehandlungsschritts zu Wolframsilizid reagiert hat, nicht angegriffen, während der Teil der Wolframschicht, der auf dem Siliziumnitrid oder Siliziumdioxid abgeschieden war, sowie gegebenenfalls der nicht umgesetzte Teil der auf dem Silizium abgeschiedenen Wolframschicht wieder entfernt wird. Entsprechend liegt nach diesem selektiven Ätzschritt eine selbstjustierte Wolframsilizidschicht vor, die die zuvor freiliegenden Siliziumbereiche bedeckt. Somit ist sichergestellt, daß nach der nachfolgenden Abscheidung des Dielektrikums keine freiliegenden Siliziumbereiche in direktem Kontakt mit dem Dielektrikum stehen, wodurch die Leckströme minimiert werden.

Als alternative Verfahren zur selbstjustierten Bildung von Metallsilizid können selbstverständlich die vorstehend näher beschriebenen Verfahren verwendet werden.

Gegebenenfalls kann darauf folgend ein zweiter Temperaturbehandlungsschritt bei 960°C in einer Stickstoffatmosphäre durchgeführt werden (N₂-RTP, "Rapid Thermal Annealing"). Durch diesen Schritt werden das gebildete WS iₓ restrukturiert und freie Wolfram- und Silizium-Bindungen durch Stickstoff abgesättigt.

Nachfolgend wird als Kondensatordielektrikum eine 5 nm dicke dielektrische Schicht 14 abgeschieden, die SiO₂ und Si₃N₄ sowie gegebenenfalls Siliziumoxynitrid enthält. Diese Schichtabfolge kann durch Schritte zur Nitridabscheidung und zur thermischen Oxidation, bei der Defekte in der darunterliegenden Schicht ausgeheilt werden, realisiert werden. Alternativ enthält die dielektrische Schicht 14 Al₂O₃ (Aluminiumoxid), TiO₂ (Titandioxid), Ta₂O₅ (Tantaloxid). Anschließend wird eine 200 nm dicke in-situ dotierte Polysiliziumschicht 15 abgeschieden, wie in Figur 6 gezeigt ist. Durch chemisch-mechanisches Polieren wird die Polysiliziumschicht 15 bis auf die Oberfläche der Si₃N₄-Schicht 4 entfernt.

Darauf folgend wird der standardmäßige DRAM-Prozeß durchgeführt, durch den die obere Kondensatorelektrode geeignet strukturiert und an das Source-/Drain-Gebiet eines Auswahltransistors angeschlossen wird.

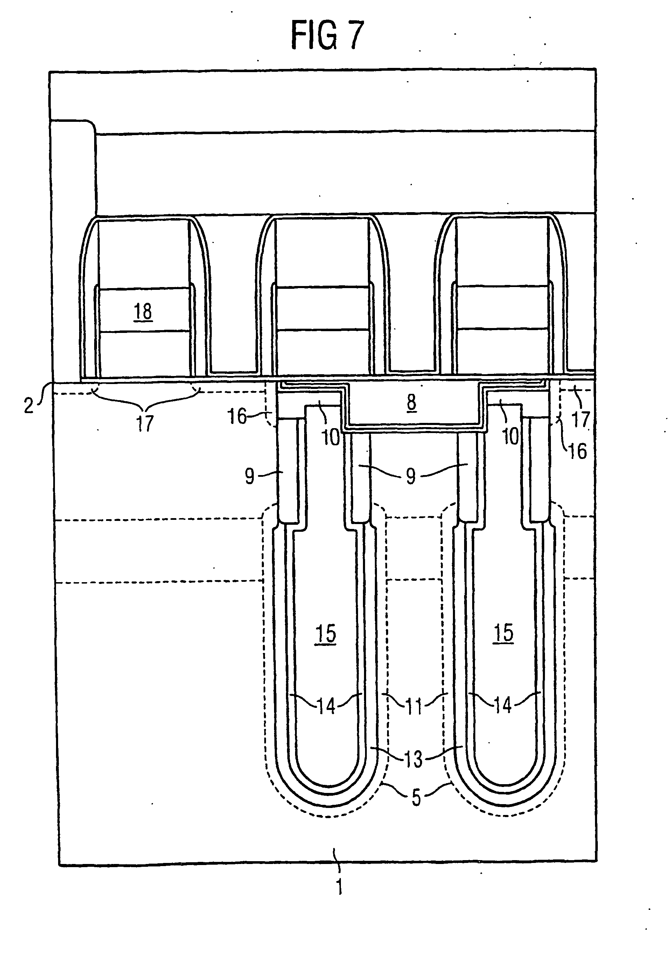

Dies kann beispielsweise durch Ätzen der Polysiliziumfüllung 15 auf etwa 100 nm unterhalb der Hauptfläche 2 geschehen. Es folgt eine Si₃N₄-Ätzung mit HF/Ethylenglycol, bei der 10 nm Si₃N₄ geätzt werden und eine Ätzung mit NH₄F/HF, mit der SiO₂ und dielektrisches Material geätzt werden. Nach einer Sacrifical oxidation zur Bildung eines Streuoxids (nicht dargestellt) wird eine Implantation durchgeführt, bei der ein n⁺-dotiertes Gebiet 16 in der Seitenwand jedes Grabens 5 im Bereich der Hauptfläche 2 gebildet wird. Wie in Figur 7 gezeigt ist, wird oberhalb der Polysiliziumfüllung 15 verbliebener Freiraum in dem jeweiligen Graben 5 durch Abscheidung von in-situ-dotiertem Polysilizium und Rückätzen des Polysiliziums mit SF₆ mit einer Polysiliziumfüllung 10 aufgefüllt. Die Polysiliziumfüllung 15 wirkt im fertigen Speicherkondensator als obere Kondensatorelektrode. Die Polysiliziumfüllung 10 wirkt als Anschlußstruktur zwischen dem n⁺-dotierten Gebiet 16 und der als obere Kondensatorelektrode wirkenden Polysiliziumfüllung 15.

Nachfolgend werden Isolationsstrukturen 8 erzeugt, die die aktiven Gebiete umgeben und damit definieren. Dazu wird eine Maske gebildet, die die aktiven Gebiete definiert (nicht dargestellt). Durch nicht-selektvies Plasma-Ätzen von Silizium, Siliziumnitrid, SiO₂ und Polysilizium mit Hilfe von CHF₃/N₂/NF₃, wobei die Ätzdauer so eingestellt wird, daß 200 nm Polysilizium geätzt werden, durch Entfernen der dabei verwendeten Lackmaske mit O₂/N₂, durch naßchemisches Ätzen von 3 nm dielektrischer Schicht, durch Oxidation und Abscheidung einer 5 nm dicken Si₃N₄-Schicht und durch Abscheidung einer 250 nm dicken SiO₂-Schicht in einem TEOS-Verfahren und anschließendes chemisch-mechanisches Polieren werden die Isolationsstrukturen 8 fertiggestellt. Durch Ätzen in heißer H₃PO₄ wird nachfolgend die Si₃N₄-Schicht 4 und durch Ätzen in verdünnter Flußsäure die SiO₂-Schicht 3 entfernt.

Durch eine Sacrifical oxidation wird nachfolgend ein Streuoxid gebildet. Es werden photolithographisch erzeugte Masken und Implantationen eingesetzt zur Bildung von n-dotierten Wannen, p-dotierten Wannen und zur Durchführung von Einsatzspannungsimplantationen im Bereich der Peripherie und der Auswahltransistoren des Zellenfelds. Ferner wird eine hochenergetische Ionenimplantation zur Dotierung des Substratbereichs, welcher von der Hauptfläche 2 abgewandt ist, durchgeführt. Dadurch wird ein n⁺-dotiertes Gebiet, das benachbarte untere Kondensatorelektroden 13 miteinander verbindet, gebildet (sogenannter "buried-well implant").

Nachfolgend wird durch allgemein bekannte Verfahrensschritte der Transistor fertiggestellt, indem jeweils das Gateoxid sowie die Gate-Elektroden 18, entsprechende Leiterbahnen, und die Source- und Drain-Elektrode 17 definiert werden.

Danach wird die Speicherzelle in bekannter Weise durch die Bildung weiterer Verdrahtungsebenen fertiggestellt.

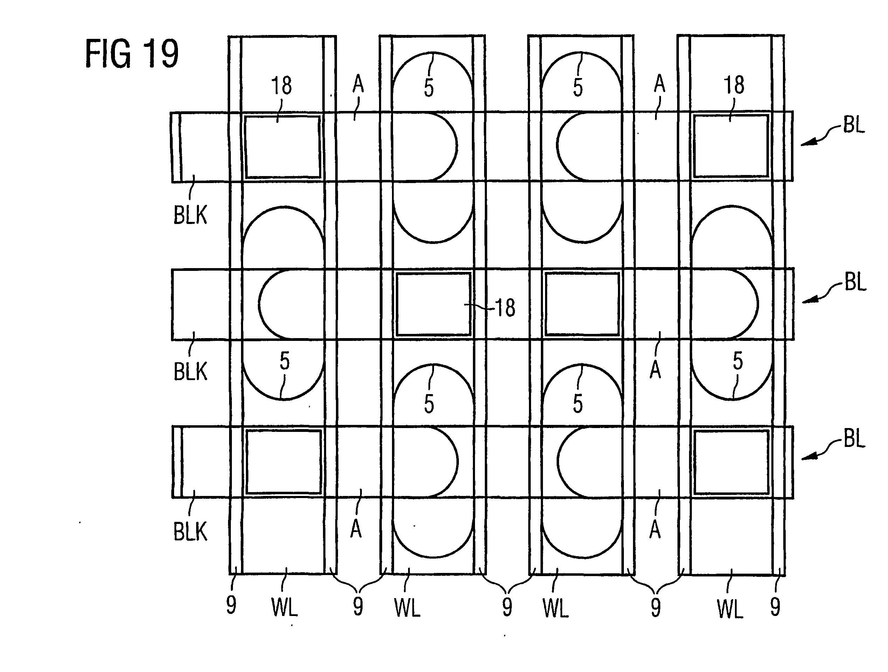

Die Speicherzellenanordnung, deren Layout für eine 8-F²-Zellarchitektur beispielhaft in Figur 19 dargestellt ist, weist je Speicherzelle einen in einem der Gräben 5 angeordneten Speicherkondensator und einen planaren Auswahltransistor auf. Pro Speicherzelle ist ein Platzbedarf von 8F² erforderlich, wobei F die kleinste herstellbare Strukturgröße in der jeweiligen Technologie ist. Die Bitleitungen BL verlaufen streifenförmig und parallel zueinander, wobei die Breite der Bitleitung BL jeweils F und ihr gegenseitige Abstand ebenfalls F beträgt. Senkrecht dazu verlaufen die Wortleitungen WL, die ebenfalls eine Breite von F und einen gegenseitigen Abstand von F aufweisen. Unterhalb der Bitleitungen BL sind aktive Gebiete A angeordnet, wobei oberhalb jedes aktiven Gebietes zwei Wortleitungen WL kreuzen. Die aktiven Gebiete A sind unterhalb benachbarter Bitleitungen BL jeweils versetzt gegeneinander angeordnet. In der Mitte der aktiven Gebiete A ist ein Bitleitungskontakt BLK angeordnet, der eine elektrische Verbindung zwischen der jeweiligen Bitleitung BL und dem aktiven Gebiet A ermöglicht. Die Gräben 5 sind unterhalb der Wortleitung WL angeordnet. Innerhalb der aktiven Gebiete ist am Kreuzungspunkt zwischen einer der Bitleitungen BL und einer der Wortleitungen WL jeweils die Gateelektrode 26 des zugehörigen Auswahltransistor angeordnet.

Die aktiven Gebiete A erstrecken sich jeweils zwischen zwei Gräben 5. Sie umfassen zwei Auswahltransistoren, die über einen gemeinsamen Bitleitungskontakt BLK mit der zugehörigen Bitleitung BL verbunden sind. Je nach dem, welche der Wortleitungen WL angesteuert wird, wird die Information aus dem Speicherkondensator, der in einem oder dem anderen der Gräben 5 angeordnet ist, ausgelesen.

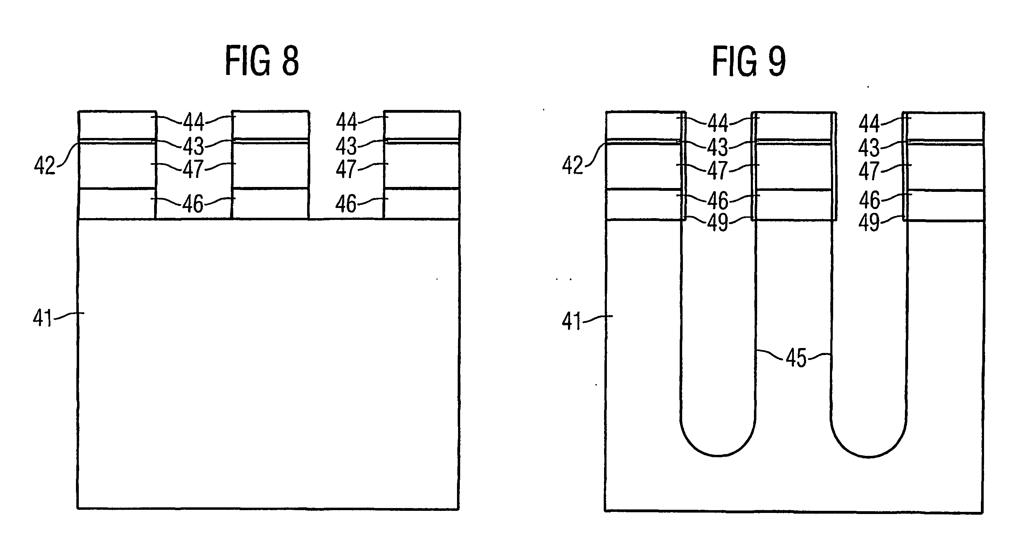

Gemäß einem weiteren Ausführungsbeispiel wird, wie in Figur 8 dargestellt, ein SOI-Substrat 41, das heißt, ein Siliziumsubstrat mit einer vergrabenen SiO₂-Schicht 46 verwendet. Auf einer Hauptfläche 42 des SOI-Substrats 41 wird eine SiO₂-Schicht 43 in einer Dicke von 5 nm und eine Si₃N₄-Schicht 44 in einer Dicke von 200 nm aufgebracht. Darauf wird eine BSG-Schicht (nicht dargestellt) in einer Dicke von 1000 nm, Si₃N₄ (nicht dargestellt) in einer Dicke von 200 nm und Polysilizium (nicht dargestellt) in einer Dicke von 350 nm jeweils als Hartmaskenmaterial abgeschieden. Mit Hilfe einer photolithographisch strukturierten Maske (nicht dargestellt), die die Anordnung der Speicherkondensatoren definiert, wird durch Plasma-Ätzen mit CHF₃/O₂ die Polysiliziumschicht, die Siliziumnitridschicht, die BSG-Schicht und die Nitridschicht geätzt. Sodann werden die aktive Si-Schicht 47 durch Plasma-Ätzen mit HBr/NF₃ und die vergrabene Oxidschicht 46 durch Plasma-Ätzen mit CHF₃/O₂ geätzt. Die Parameter dieses Ätzschritts sind derart bemessen, daß die Gräben nur bis zum unteren Ende der vergrabenen Oxidschicht 46 geätzt werden.

Nach Entfernung der BSG-Maske wird eine 5 nm dicke Si₃N₄-Schicht 49 als Spacermaterial abgeschieden. Da bei dieser Ausführungsform der parasitäre Transistor durch die vergrabene SiO₂-Schicht vermieden wird, hat die Si₃N₄-Schicht in diesem Fall nicht die Funktion, diesen parasitären Transistor abzuschalten. Ihre Aufgabe ist vielmehr, die Diffusion von Dotierstoffen während eines nachfolgenden Schritts zur Dotierung des Substrats durch Dotierung aus der Gasphase oder aus der dotierten SiO₂-Schicht im oberen Kondensatorbereich (aktives Gebiet 47) zu verhindern. Für diese Aufgabe ist eine Dicke von 5 nm ausreichend. Sodann werden die Kondensatorgräben 45 bis zu einer Tiefe von 5 µm durch Plasma-Ätzen mit HBr/NF₃ geätzt, wie in Figur 9 veranschaulicht ist.

Die Ätzung der Kondensatorgräben kann dabei derart erfolgen, daß die Gräben 45 in ihrem unteren Bereich, d.h. in dem der Hauptfläche 42 abgewandten Bereich, aufgeweitet werden. Beispielsweise kann der Querschnitt im unteren Bereich der Gräben 45 um 40 nm aufgeweitet werden. Dadurch kann die Kondensatorfläche und damit die Kapazität des Kondensators weiter vergrößert werden.

In den Zeichnungen ist der Prozeßablauf mit nicht aufgeweiteten Gräben veranschaulicht.

Anschließend erfolgt eine Dotierung des Silizium-Substrats. Dies kann beispielsweise durch Abscheidung einer Arsen-dotierten Silikatglasschicht in einer Schichtdicke von 50 nm und einer TEOS-SiO₂-Schicht in einer Dicke von 20 nm und einen anschließenden Temperaturbehandlungsschritt bei 1000°C, 120 Sekunden, wodurch durch Ausdiffusion aus der Arsen-dotierten Silikatglasschicht in dem Siliziumsubstrat 41 ein n⁺-dotiertes Gebiet 58 gebildet wird, geschehen. Alternativ kann auch eine Gasphasendotierung durchgeführt werden, zum Beispiel mit folgenden Parametern: 900°C, 399 Pa Tributylarsin (TBA) [33 Prozent], 12 min.

Durch das n⁺-dotierte Gebiet 58 wird die Verarmungszone verkleinert, wodurch die Kapazität des Kondensators weiter erhöht wird. Bei Verwendung einer metallischen Bottom-Elektrode dient diese dotierte Schicht zur Herstellung eines ohmschen Kontaktes zwischen Substrat und Metall.

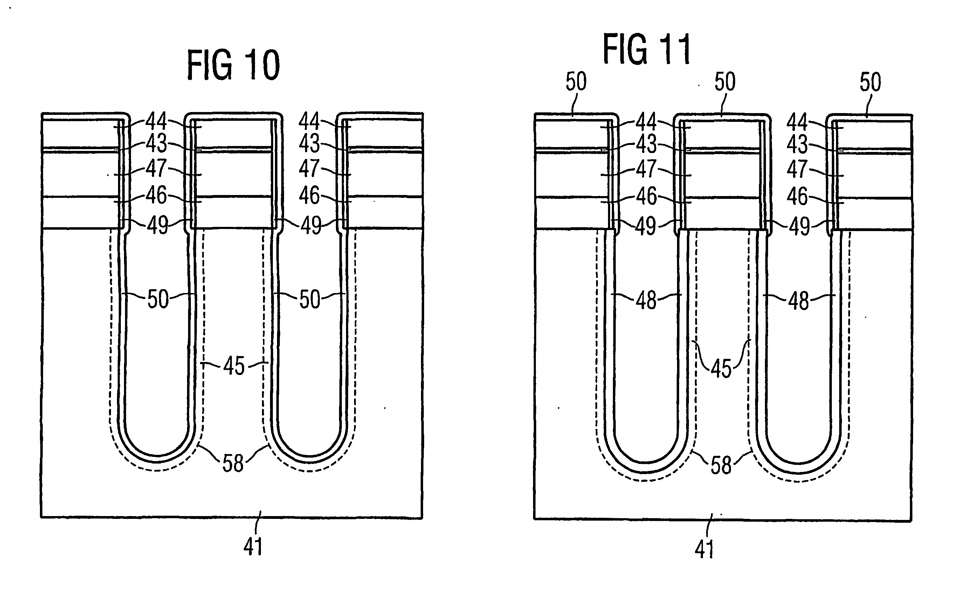

Darauf folgend wird eine 10 nm dicke Wolframschicht 50 beispielsweise durch ein CVD-Verfahren ganzflächig abgeschieden (siehe Figur 10).

In einem nachfolgenden Temperaturbehandlungsschritt bei 600 bis 800°C in einer Stickstoffatmosphäre (N₂-RTP, "Rapid Thermal Annealing") wird das selbstjustierte Wolframsilizid gebildet. Genauer gesagt, bildet sich nur an den Stellen, an denen das Wolfram direkt auf dem Silizium abgeschieden wurde, Wolframsilizid 48, während das Metall, das direkt auf dem Nitrid abgeschieden wurde, nicht mit dem Substrat reagiert. Dies ist in Figur 11 veranschaulicht. Eine geringfügige Aufweitung der Kondensatorgräben ergibt sich bei diesem Schritt dadurch, daß für die Wolframsilizidbildung Silizium an den Wänden der Gräben verbraucht wird.

Gemäß einer bevorzugten Ausführungsform kann dieser Temperaturbehandlungsschritt so eingestellt werden, daß nicht das komplette Wolfram durchsilizidiert wird. Dadurch können, wie vorstehend beschrieben, besonders dünne Metallelektroden realisiert werden. Zusätzlich können Inhomogenitäten in der Schichtdicke des Metalls ausgeglichen werden.

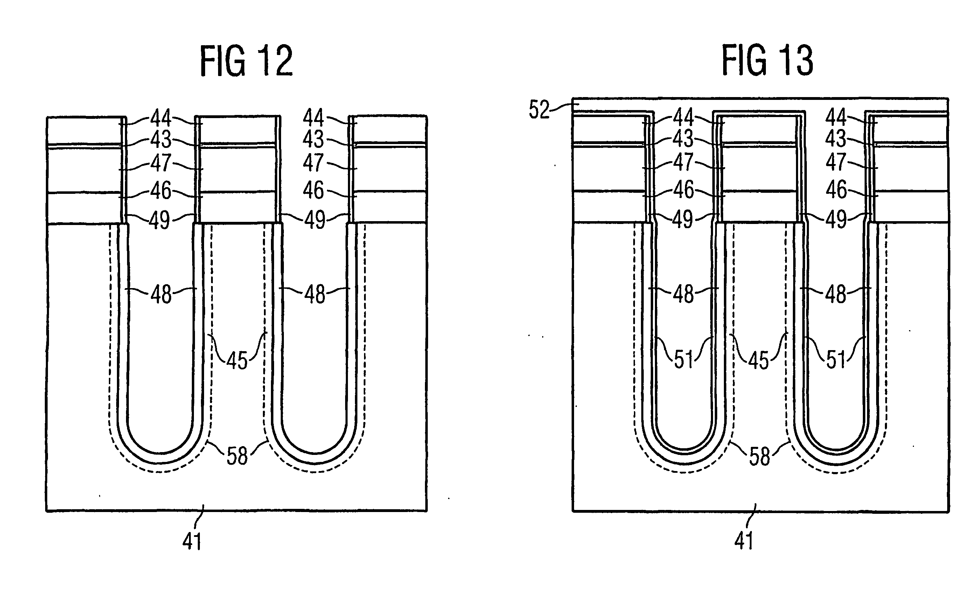

Schließlich wird das Wolfram selektiv zum Wolframsilizid 48 geätzt. Dies kann beispielsweise durch Naßätzen in H₂O/NH₄OH/H₂O₂ erfolgen (siehe Figur 12) .

Durch diesen Schritt wird der Teil der Wolframschicht, der auf dem freiliegenden Silizium abgeschieden war und mit diesem während des Temperaturbehandlungsschritts zu Wolframsilizid reagiert hat, nicht angegriffen, während der Teil der Wolframschicht, der auf dem Siliziumnitrid oder Siliziumdioxid abgeschieden war, sowie gegebenenfalls der nicht umgesetzte Teil der auf dem Silizium abgeschiedenen Wolframschicht wieder entfernt wird. Entsprechend liegt nach diesem selektiven Ätzschritt eine selbstjustierte Wolframsilizidschicht vor, die die zuvor freiliegenden Siliziumbereiche bedeckt.

Gegebenenfalls kann darauf folgend ein zweiter Temperaturbehandlungsschritt bei 960°C in einer Stickstoffatmosphäre durchgeführt werden (N₂-RTP, "Rapid Thermal Annealing"). Durch diesen Schritt werden das gebildete WS iₓ restrukturiert und freie Wolfram- und Silizium-Bindungen durch Stickstoff abgesättigt.

Nachfolgend wird als Kondensatordielektrikum eine 5 nm dicke dielektrische Schicht 51 abgeschieden, die SiO₂ und Si₃N₄ sowie gegebenenfalls Siliziumoxynitrid enthält. Alternativ enthält die dielektrische Schicht 51 Al₂O₃ (Aluminiumoxid), TiO₂ (Titandioxid), Ta₂O₅ (Tantaloxid). Anschließend wird eine 200 nm dicke in-situ dotierte Polysiliziumschicht 52 abgeschieden, wie in Figur 13 gezeigt ist. Durch chemisch-mechanisches Polieren wird die Polysiliziumschicht 52 bis auf die Oberfläche der Si₃N₄-Schicht 44 entfernt.

Darauf folgend wird der standardmäßige DRAM-Prozeß durchgeführt, durch den die obere Kondensatorelektrode geeignet strukturiert und an die Source- oder Drain-Elektrode 56 eines Auswahltransistors angeschlossen wird.

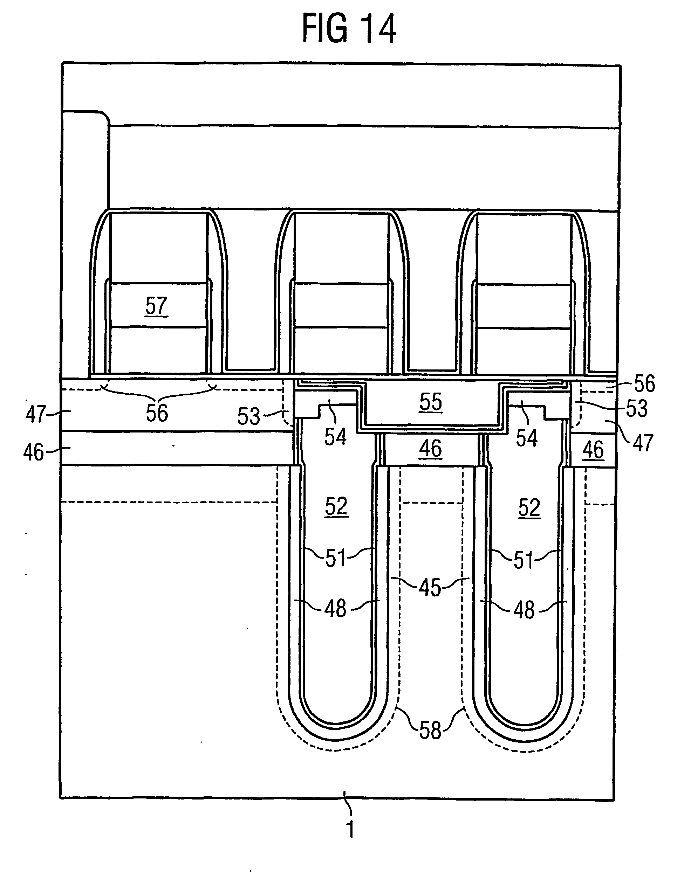

Dies kann beispielsweise durch Ätzen der Polysiliziumfüllung 52 auf etwa 100 nm unterhalb der Hauptfläche 42 geschehen. Es folgt eine Si₃N₄-Ätzung mit HF/Ethylenglycol, bei der 10 nm Si₃N₄ geätzt werden und eine Ätzung mit NH₄F/HF, mit der SiO₂ und dielektrisches Material geätzt werden. Nach einer Sacrifical oxidation zur Bildung eines Streuoxids (nicht dargestellt) wird eine Implantation durchgeführt, bei der ein n⁺-dotiertes Gebiet 53 in der Seitenwand jedes Grabens 45 im Bereich der Hauptfläche 42 gebildet wird. Wie in Figur 14 gezeigt ist, wird oberhalb der Polysiliziumfüllung 52 verbliebener Freiraum in dem jeweiligen Graben 45 durch Abscheidung von insitu-dotiertem Polysilizium und Rückätzen des Polysiliziums mit SF₆ mit einer Polysiliziumfüllung 54 aufgefüllt.

Die Polysiliziumfüllung 52 wirkt im fertigen Speicherkondensator als obere Kondensatorelektrode. Die Polysiliziumfüllung 54 wirkt als Anschlußstruktur zwischen dem n⁺-dotierten Gebiet 53 und der als obere Kondensatorelektrode wirkenden Polysiliziumfüllung 52.

Nachfolgend werden Isolationsstrukturen 55 erzeugt, die die aktiven Gebiete umgeben und damit definieren. Dazu wird eine Maske gebildet, die die aktiven Gebiete definiert (nicht dargestellt). Durch nicht-selektvies Plasma-Ätzen von Silizium, Siliziumnitrid, SiO₂ und Polysilizium mit Hilfe von CHF₃/N₂/NF₃, wobei die Ätzdauer so eingestellt wird, daß 200 nm Polysilizium geätzt werden, durch Entfernen der dabei verwendeten Lackmaske mit O₂/N₂, durch naßchemisches Ätzen von 3 nm dielektrischer Schicht, durch Oxidation und Abscheidung einer 5 nm dicken Si₃N₄-Schicht und durch Abscheidung einer 250 nm dicken SiO₂-Schicht in einem TEOS-Verfahren und anschließendes chemisch-mechanisches Polieren werden die Isolationsstrukturen 55 fertiggestellt. Durch Ätzen in heißer H₃PO₄ wird nachfolgend die Si₃N₄-Schicht 44 und durch Ätzen in verdünnter Flußsäure die SiO₂-Schicht 43 entfernt.

Durch eine Sacrifical oxidation wird nachfolgend ein Streuoxid gebildet. Es werden photolithographisch erzeugte Masken und Implantationen eingesetzt zur Bildung von n-dotierten Wannen, p-dotierten Wannen und zur Durchführung von Einsatzspannungsimplantationen im Bereich der Peripherie und der Auswahltransistoren des Zellenfelds. Ferner wird eine hochenergetische Ionenimplantation zur Dotierung des Substratbereichs, welcher von der Hauptfläche 42 abgewandt ist, durchgeführt. Dadurch wird ein n⁺-dotiertes Gebiet, das benachbarte untere Kondensatorelektroden 48 miteinander verbindet, gebildet.

Nachfolgend wird durch allgemein bekannte Verfahrensschritte der Transistor fertiggestellt, indem jeweils das Gateoxid sowie die Gate-Elektroden 57, entsprechende Leiterbahnen, und die Source- und Drain-Elektrode 56 definiert werden.

Danach wird die Speicherzelle in bekannter Weise durch die Bildung weiterer Verdrahtungsebenen fertiggestellt.

Gemäß der vorliegenden Erfindung kann das Verfahren zur Herstellung der unteren Kondensatorelektrode auch auf einen Stapelkondensator einer DRAM-Speicherzelle angewendet werden. Im Gegensatz zu den vorstehend beschriebenen Herstellungsverfahren wird dabei die untere Kondensatorelektrode nicht in einem in einem Silizium-Material gebildeten Graben gebildet sondern auf der Oberfläche einer Polysilizium-Kontaktstruktur, die den Source/Drain-Bereich des Auswahltransistors mit der unteren Kondensatorelektrode verbindet.

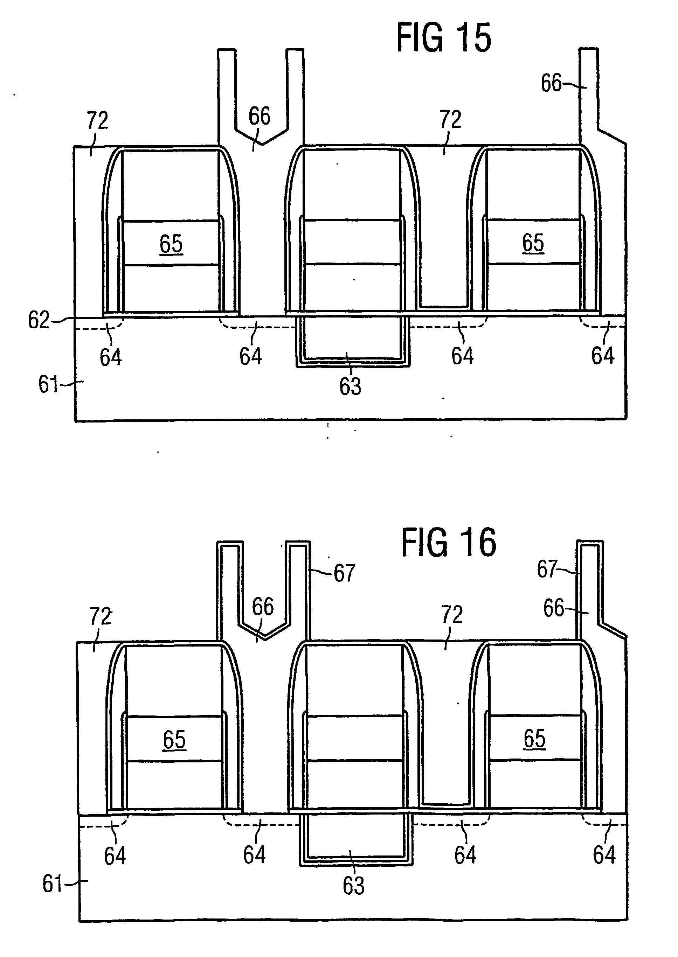

Bei dem in Figur 15 gezeigten Verfahren werden auf einem Siliziumsubstrat Strukturen gemäß dem Standard-DRAM-Prozeß für Stapelkondensatoren erzeugt. Genauer gesagt, werden wie in Figur 15 gezeigt, in einer Hauptfläche 62 eines Siliziumsubstrats 61 durch allgemein bekannte Verfahren zunächst die aktiven Bereiche definiert, indem Isolationsstrukturen 63 durch Ätzen von Isolationsgräben und Auffüllen der Isolationsgräben mit einer dünnen Si₃N₄-Schicht sowie SiO₂ gebildet werden. Sodann wird zur Herstellung der Wortleitungen erst eine dünne SiO₂-Schicht als Gateoxid durch thermische Oxidation erzeugt, darauf werden zur Herstellung der Gate-Elektroden 65 eine Polysiliziumschicht, eine Wolframsilizidschicht sowie 200 bis 300 nm Si₃N₄ ganzflächig abgeschieden und geeignet strukturiert. Anschließend werden durch thermische Oxidation eine SiO₂-Schicht und außerdem durch ein Nitridabscheideverfahren eine Si₃N₄-Schicht als SpacerSchicht aufgebracht und anschließend strukturiert, so daß die seitlichen Flanken der Gate-Elektroden 65 mit diesen Schichten bedeckt sind.

Nach sogenannter folded-Bitline-Architektur dient die in Figur 15 dargestellte mittlere Wortleitung als sogenannte "passing wordline", das heißt als Wortleitung für die Gate-Elektrode der vor oder hinter der Zeichenebene befindlichen Speicherzelle.

Darauf folgend werden die Source- und Drain-Elektroden 64 selbstjustiert unter Verwendung der Gate-Elektroden 65 als Implantations-Masken durch Ionenimplantation gebildet.

Anschließend werden die Zwischenräume zwischen den Wortleitungen durch Abscheiden von BSG bzw. BPSG und eine anschließende Temperaturbehandlung, bei der das BSG bzw. BPSG 72 verfließt, aufgefüllt. Auf der sich ergebenden Oberfläche wird durch ein TEOS-Verfahren SiO₂ (nicht gezeigt) aufgebracht. An den Stellen, an denen die Kontaktstrukturen 66 zwischen unterer Kondensatorelektrode 67 und Source- bzw. Drain-Elektrode 64 des Auswahltransistors gebildet werden sollen, werden Kontaktlöcher durch das SiO₂ und das BSG 72 selektiv zu Si₃N₄ bis auf den Source-/Drain-Bereich geätzt.

Anschließend wird eine in-situ dotierte Polysiliziumschicht 66 mit einer derartig bemessenen Dicke aufgebracht, daß der untere Teil der Kontaktlöcher, welcher sich zwischen benachbarten Wortleitungen erstreckt, vollständig mit Polysilizium aufgefüllt wird, während der obere Teil der Kontaktlöcher, der sich durch die SiO₂-Schicht erstreckt, mit einer dünnen Poly-Silizium-Schicht ausgekleidet wird, d.h. es bilden sich an dieser Stelle Hohlzylinder oder Becher. Das auf der SiO₂-Oberfläche abgeschiedene Polysilizium wird durch chemisch-mechanisches Polieren entfernt, anschließend wird das SiO₂ an der Oberfläche weggeätzt. Es ergibt sich der in Figur 15 gezeigte Aufbau.

Nun wird beispielsweise durch ein CVD-Verfahren eine dünne Wolframschicht ganzflächig abgeschieden.

In einem nachfolgenden Temperaturbehandlungsschritt bei 600 bis 800°C in einer Stickstoffatmosphäre (N₂-RTP, "Rapid Thermal Annealing") wird das selbstjustierte Wolframsilizid 67 gebildet. Genauer gesagt, bildet sich nur an den Stellen, an denen das Wolfram direkt auf dem Silizium abgeschieden wurde, Wolframsilizid, während das Metall, das direkt auf dem Nitrid oder den mit BSG gefüllten Zwischenräumen abgeschieden wurde, nicht mit dem Substrat reagiert.

Dieser Temperaturbehandlungsschritt kann so eingestellt werden, daß nicht das komplette Wolfram durchsilizidiert wird. Dadurch können, wie vorstehend beschrieben, besonders dünne Metallelektroden realisiert werden.

Schließlich wird das Wolfram selektiv zum Wolframsilizid geätzt. Dies kann beispielsweise durch Naßätzen in H₂O/NH₄OH/H₂O₂ erfolgen (siehe Figur 16).

Durch diesen Schritt wird der Teil der Wolframschicht, der auf dem freiliegenden Silizium abgeschieden war und mit diesem während des Temperaturbehandlungsschritts zu Wolframsilizid reagiert hat, nicht angegriffen, während der Teil der Wolframschicht, der auf dem Siliziumnitrid oder BSG abgeschieden war, sowie gegebenenfalls der nicht umgesetzte Teil der auf dem Silizium abgeschiedenen Wolframschicht wieder entfernt wird. Entsprechend liegt nach diesem selektiven Ätzschritt eine selbstjustierte Wolframsilizidschicht 67 vor, die die zuvor selektiv aufgebrachten Siliziumbereiche bedeckt.

Gegebenenfalls kann darauf folgend ein zweiter Temperaturbehandlungsschritt bei ungefähr 800°C in einer Stickstoffatmosphäre durchgeführt werden (N₂-RTP, "Rapid Thermal Annealing"). Durch diesen Schritt werden das gebildete WS iₓ restrukturiert und freie Wolfram- und Silizium-Bindungen durch Stickstoff abgesättigt.

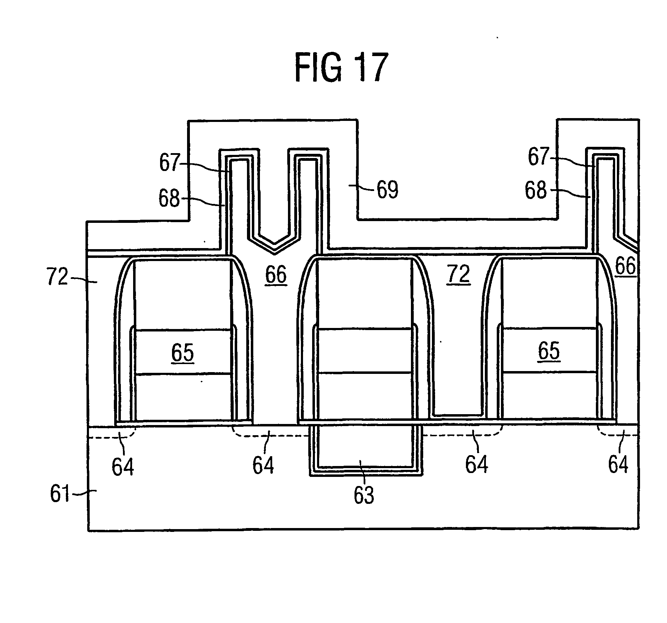

Nachfolgend wird als Kondensatordielektrikum eine 5 nm dicke dielektrische Schicht 68 abgeschieden, die SiO₂ und Si₃N₄ sowie gegebenenfalls Siliziumoxynitrid enthält. Alternativ enthält die dielektrische Schicht 68 Al₂O₃ (Aluminiumoxid), TiO₂ (Titandioxid), Ta₂O₅ (Tantaloxid). Anschließend wird eine Wolframsilizidschicht als obere Kondensatorelektrode 69 abgeschieden, wie in Figur 17 gezeigt ist. Die Dicke der Wolframsilizidschicht kann dabei derartig bemessen sein, daß der mit unterer Kondensatorelektrode und Dielektrikum ausgekleidete Becher vollständig aufgefüllt wird, das heißt, die Dicke der abgeschiedenen Schicht beträgt ungefähr 50 bis 100 nm.

Nach Strukturierung der dielektrischen Schicht und der oberen Kondensatorelektrode durch bekannte Verfahren werden weitere Isolationsschichten erzeugt, Bitleitungskontakte 70 hergestellt und anschließend die Bitleitungen 71 definiert.

Das beschriebene Verfahren ist dahingehend vorteilhaft gegenüber dem herkömmlichen Verfahren zur Bildung von Stapelkondensatoren, daß die Verbindungsstruktur aus Polysilizium vor der Abscheidung des Metalls geeignet strukturiert wird, so daß nur an den Stellen, an denen die untere Kondensatorelektrode gebildet werden soll, freiliegende Siliziumbereiche vorhanden sind. Entsprechend wird nur an diesen Stellen Metallsilizid gebildet bzw. abgeschieden, so daß in den darauffolgenden Schritten kein Metallsilizid mehr entfernt werden muß. Dadurch kann das Verfahren zur Herstellung der unteren Kondensatorelektrode erheblich vereinfacht werden.

### Bezugszeichenliste

- 1: Silizium-Substrat
- 2: Hauptfläche
- 3: SiO₂-Schicht
- 4: Si₃N₄-Schicht
- 5: Graben
- 6: SiO₂-Schicht
- 7: Polysilizium
- 8: Isolationsstruktur
- 9: Si₃N₄-Spacer
- 10: Polysiliziumfüllung
- 11: n⁺-dotierter Bereich
- 12: Wolfram
- 13: Wolframsilizid
- 14: Kondensatordielektrikum
- 15: obere Kondensatorelektrode
- 16: n⁺-dotiertes Gebiet
- 17: Source- bzw. Drain-Elektrode
- 18: Gate-Elektrode
- 41: SOI-Substrat
- 42: Hauptfläche
- 43: SiO₂-Schicht
- 44: Si₃N₄-Schicht
- 45: Graben
- 46: vergrabene SiO₂-Schicht
- 47: aktives Gebiet
- 48: Wolframsilizid
- 49: Si₃N₄-Spacer
- 50: Wolfram
- 51: Kondensatordielektrikum
- 52: obere Kondensatorelektrode
- 53: n⁺-dotiertes Gebiet
- 54: Polysilizium
- 55: Isolationsstruktur
- 56: Source- bzw. Drain-Elektrode
- 57: Gate-Elektrode
- 58: n⁺-dotiertes Gebiet
- 61: Si-Substrat
- 62: Hauptfläche
- 63: Isolationsstruktur
- 64: Source-/Drain-Elektrode
- 65: Gate-Elektrode
- 66: Kontaktstruktur
- 67: Wolframsilizid
- 68: Kondensatordielektrikum
- 69: obere Kondensatorelektrode
- 70: Bitleitungskontakt
- 71: Bitleitung
- 72: BSG

## Patentansprüche

1. Verfahren zur Herstellung eines Speicherkondensators mit vertikalem Aufbau in Bezug auf eine Hauptfläche eines Substrats, insbesondere zur Verwendung in einer DRAM-Speicherzelle, bei dem eine untere metallische Kondensatorelektrode (13, 48, 67), ein Speicherdielektrikum (14, 51, 68) und eine obere Kondensatorelektrode (15, 52, 69) in oder auf der Hauptfläche des Substrats gebildet werden, wobei die untere metallische Kondensatorelektrode (13, 48, 67) in der Weise selbstjustiert auf einem Silizium-Grundmaterial (1, 41, 66) gebildet wird, daß zunächst freiliegende Silizium-Bereiche an den Stellen, an denen die untere Kondensatorelektrode zu bilden ist, erzeugt werden und sodann auf den freiliegenden Silizium-Bereichen Metallsilizid selektiv gebildet wird,
**dadurch gekennzeichnet, daß**
der Schritt der selektiven Bildung von Metallsilizid (13, 48, 67) auf den freiliegenden Siliziumbereichen den Schritt zur selektiven Abscheidung des Metallsilizids auf den freiliegenden Siliziumbereichen (1, 41, 66) aus der Gasphase umfaßt.

2. Verfahren zur Herstellung eines Grabenkondensators, insbesondere zur Verwendung in einer DRAM-Speicherzelle, mit den Schritten:
- Ätzen eines Grabens (5, 45) in eine Hauptfläche (2, 42) eines Halbleitersubstrats (1, 41);
- Durchführen des Verfahrens nach Anspruch 1, wobei der Speicherkondensator zumindest teilweise in dem Graben (5, 45) angeordnet wird und die untere metallische Kondensatorelektrode (13, 48) an eine Wand des Grabens angrenzt; und
- Bereitstellen eines Speicherdielektrikums (14, 51) und einer oberen Kondensatorelektrode (15, 52).

3. Verfahren nach einem der vorhergehenden Ansprüche,
**dadurch gekennzeichnet, daß**
der Schritt der Bildung freiliegender Silizium-Bereiche (1, 41) das Aufbringen eines Abdeckmaterials (9, 49) auf einem Silizium-Grundmaterial umfaßt.

4. Verfahren nach Anspruch 3,
**dadurch gekennzeichnet, daß**
das Abdeckmaterial (9, 49) aus Siliziumnitrid oder Siliziumdioxid oder einer Kombination dieser Materialien ausgewählt ist.

5. Verfahren zur Herstellung einer Speicherzelle mit einem Speicherkondensator, der als Grabenkondensator ausgeführt ist, und einem Auswahltransistor, mit den Schritten:
- Ätzen eines Grabens (5, 45) in eine Hauptfläche (2, 42) eines Siliziumsubstrats (1, 41);
- Durchführen des Verfahrens nach Anspruch 3 oder 4, wobei der Speicherkondensator zumindest teilweise in dem Graben (5, 45) angeordnet wird und die untere metallische Kondensatorelektrode (13, 48) an eine Wand des Grabens angrenzt; und
- Bilden des Auswahltransistors mit Source-Elektrode, Drain-Elektrode (17, 56), leitendem Kanal und Gate-Elektrode (18, 57), wobei die obere Kondensatorelektrode (13, 48) mit der Source- oder Drain-Elektrode (17, 56) des Auswahltransistors elektrisch leitend verbunden wird.

6. Verfahren nach Anspruch 5,
**dadurch gekennzeichnet, daß**
das Substrat (1, 41) ein Siliziumsubstrat oder ein auf einem Isolator angeordnetes Siliziumubstrat ist.

7. Verfahren zur Herstellung eines Stapelkondensators, insbesondere zur Verwendung in einer DRAM-Speicherzelle, mit den Schritten:
- strukturiertes Aufbringen einer Polysiliziumschicht (66), welche für die Verwendung als elektrisch leitende Verbindungsstruktur zwischen unterer Kondensatorelektrode und Source- oder Drain-Elektrode eines Auswahltransistors der DRAM-Speicherzelle geeignet ist, auf einem nicht-Siliziummaterial;
- Durchführen des Verfahrens nach Anspruch 1 zur selbstjustierten Bildung der unteren metallischen Kondensatorelektrode (67); und
- Bereitstellen eines Speicherdielektrikums (68) und einer oberen Kondensatorelektrode (69).

8. Verfahren nach Anspruch 1,
**dadurch gekennzeichnet, daß**
der Schritt der Bildung freiliegender Silizium-Bereiche das strukturierte Aufbringen einer Silizium- oder Polysiliziumschicht (66) auf einem nicht-Siliziummaterial umfaßt.

9. Verfahren zur Herstellung einer Speicherzelle mit einem Speicherkondensator, der als Stapelkondensator ausgeführt ist, und einem Auswahltransistor, mit
- dem Schritt des Bildens eines Auswahltransistors mit Source-Elektrode, Drain-Elektrode (64), leitendem Kanal und Gate-Elektrode (65) auf einer Hauptfläche (62) eines Halbleitersubstrats (61),
- den Schritten des Verfahrens nach Anspruch 8, so daß die untere Kondensatorelektrode (67) auf einer elektrisch leitenden Verbindungsstruktur (66) aus Polysilizium, die die untere Kondensatorelektrode (67) mit der Source- oder Drain-Elektrode (64) des Auswahltransistors verbindet, auf der sich ergebenden Oberfläche gebildet wird.

10. Verfahren zur Herstellung eines Grabenkondensators, insbesondere zur Verwendung in einer DRAM-Speicherzelle, mit den Schritten:
- Ätzen eines Grabens (5, 45) in eine Hauptfläche (2, 42) eines Siliziumsubstrats (1, 41);
- Erzeugen freiliegender Silizium-Bereiche durch Aufbringen eines Abdeckmaterials (9, 49) auf den Grabenbereichen, auf denen die untere Kondensatorelektrode nicht zu bilden ist;
- selbstjustierte Bildung einer unteren metallischen Kondensatorelektrode (13, 48) aus Metallsilizid durch selektive Abscheidung eines Metalls aus einer Gasphase auf die freiliegenden Silizium-Bereiche, wobei der Speicherkondensator zumindest teilweise in dem Graben (5, 45) angeordnet wird und die untere metallische Kondensatorelektrode (13, 48) an eine Wand des Grabens angrenzt;
- nachfolgend Bilden eines Speicherdielektrikums (14, 51); und
anschließend Bilden einer oberen Kondensatorelektrode (15, 52).

11. Verfahren nach Anspruch 10,
**dadurch gekennzeichnet, daß**
das Abdeckmaterial (9, 49) aus Siliziumnitrid oder Siliziumdioxid oder einer Kombination dieser Materialien ausgewählt ist.

12. Verfahren zur Herstellung einer Speicherzelle mit einem Speicherkondensator, der als Grabenkondensator ausgeführt ist, und einem Auswahltransistor, mit den Schritten:
- Durchführen des Verfahrens nach Anspruch 10 oder 11; und
- Bilden des Auswahltransistors mit Source-Elektrode, Drain-Elektrode (17, 56), leitendem Kanal und Gate-Elektrode (18, 57), wobei die obere Kondensatorelektrode (13, 48) mit der Source- oder Drain-Elektrode (17, 56) des Auswahltransistors elektrisch leitend verbunden wird.

13. Verfahren nach Anspruch 12,
**dadurch gekennzeichnet, daß**
das Substrat (1, 41) ein Siliziumsubstrat oder ein auf einem Isolator angeordnetes Siliziumubstrat ist.

14. Verfahren nach einem der Ansprüche 10 bis 13,
**dadurch gekennzeichnet, daß**
der Schritt der selektiven Bildung von Metallsilizid auf den freiliegenden Siliziumbereichen die Schritte
- Abscheiden eines Metalls (12, 50), welches geeignet ist, in einem nachfolgenden Temperaturbehandlungsschritt mit dem freiliegenden Silizium eine Metall-Silizium-Verbindung einzugehen,
- Temperaturbehandlung bei einer vorgegebenen Temperatur in einer vorgegebenen Atmosphäre, und
- selektive Entfernung des nicht zu Silizid umgesetzten Metalls umfaßt.

15. Verfahren nach Anspruch 14,
**dadurch gekennzeichnet, daß**
der Temperaturbehandlungsschritt bei einer Temperatur von 600 bis 1000°C in einer Stickstoffatmosphäre durchgeführt wird.

16. Verfahren nach Anspruch 14 oder 15,
**dadurch gekennzeichnet, daß** die Zeitdauer des Schritts der Temperaturbehandlung derart eingestellt wird, daß nur ein den Silizium-Bereichen zugewandter Teil der Metallschicht eine Metall-Silizium-Verbindung eingeht.

17. Verfahren nach Anspruch 1,
**dadurch gekennzeichnet, daß**
das Metall aus Wolfram, Titan, Molybdän, Tantal, Kobalt, Nickel, Niob, Platin, Palladium und den Seltenerdmetallen ausgewählt ist.

18. Verfahren nach einem der vorhergehenden Ansprüche,
**dadurch gekennzeichnet, daß**
nach dem Schritt der Erzeugung freiliegender Silizium-Bereiche an diesen Bereichen oberflächenvergrößernde Maßnahmen durchgeführt werden.

## Claims

1. Method for fabricating a storage capacitor with a vertical structure with respect to a main surface of a substrate, in particular for use in a DRAM memory cell, in which a lower, metallic capacitor electrode (13, 48, 67), a storage dielectric (14, 51, 68) and an upper capacitor electrode (15, 52, 69) are formed in or on the main surface of the substrate, the lower, metallic capacitor electrode (13, 48, 67) being formed in a self-aligned manner on a silicon base material (1, 41, 66) in such a manner that, initially, uncovered silicon regions are produced at the locations at which the lower capacitor electrode is to be formed, and then metal silicide is formed selectively on the uncovered silicon regions, **characterized in that** the step of selective formation of metal silicide (13, 48, 67) on the uncovered silicon regions comprises the step for selectively depositing the metal silicide on the uncovered silicon regions (1, 41, 66) from the vapour phase.

2. Method for fabricating a trench capacitor, in particular for use in a DRAM memory cell, comprising the following steps:
- etching a trench (5, 45) into a main surface (2, 42) of a semiconductor substrate (1, 41);
- carrying out the method according to Claim 1, with the storage capacitor arranged at least partially in the trench (5, 45) and the lower, metallic capacitor electrode (13, 48) adjoining a wall of the trench; and
- providing a storage dielectric (14, 51) and an upper capacitor electrode (15, 52).

3. Method according to one of the preceding claims, **characterized in that** the step of forming uncovered silicon regions (1, 41) comprises the application of a covering material (9, 49) to a silicon base material.

4. Method according to Claim 3, **characterized in that** the covering material (9, 49) is selected from silicon nitride or silicon dioxide or a combination of these materials.

5. Method for fabricating a memory cell having a storage capacitor, which is designed as a trench capacitor, and a select transistor, comprising the following steps:
- etching a trench (5, 45) into a main surface (2, 42) of a silicon substrate (1, 41);
- carrying out the method according to Claim 3 or 4, with the storage capacitor arranged at least partially in the trench (5, 45) and the lower, metallic capacitor electrode (13, 48) adjoining a wall of the trench; and
- forming the select transistor with source electrode, drain electrode (17, 56), conductive channel and gate electrode (18, 57), the upper capacitor electrode (13, 48) being connected in an electrically conductive manner to the source or drain electrode (17, 56) of the select transistor.

6. Method according to Claim 5, **characterized in that** the substrate (1, 41) is a silicon substrate or a silicon substrate arranged on an insulator.

7. Method for fabricating a stacked capacitor, in particular for use in a DRAM memory cell, comprising the following steps:
- patterned application of a polysilicon layer (66) which is suitable for use as an electrically conductive connecting structure between lower capacitor electrode and source or drain electrode of a select transistor of the DRAM memory cell to a non-silicon material;
- carrying out the method according to Claim 1 for the self-aligned formation of the lower, metallic capacitor electrode (67); and
- providing a storage dielectric (68) and an upper capacitor electrode (69).

8. Method according to Claim 1, **characterized in that** the step of forming uncovered silicon regions comprises the patterned application of a silicon or polysilicon layer (66) to a non-silicon material.

9. Method for fabricating a memory cell having a storage capacitor, which is designed as a stacked capacitor, and a select transistor, comprising
- the step of forming a select transistor with source electrode, drain electrode (64), conductive channel and gate electrode (65) on a main surface (62) of a semiconductor substrate (61),
- the steps involved in the method according to Claim 8, so that the lower capacitor electrode (67) is formed on an electrically conductive connecting structure (66) made from polysilicon, which connects the lower capacitor electrode (67) to the source or drain electrode (64) of the select transistor, on the resulting surface.

10. Method for fabricating a trench capacitor, in particular for use in a DRAM memory cell, comprising the steps of:
- etching a trench (5, 45) into a main surface (2, 42) of a silicon substrate (1, 41);
- producing uncovered silicon regions by applying a covering material (9, 49) to the trench regions on which the lower capacitor electrode is not to be formed;
- self-aligned formation of a lower metallic capacitor electrode (13, 48) from metal silicide by selective vapour deposition of a metal on the uncovered silicon regions, with the storage capacitor being arranged at least partially in the trench (5, 45) and the lower, metallic capacitor electrode (13, 48) adjoining a wall of the trench;
- subsequent formation of a storage dielectric (14, 51); and
then formation of an upper capacitor electrode (15, 52).

11. Method according to Claim 10, **characterized in that** the covering material (9, 49) is selected from silicon nitride or silicon dioxide or a combination of these materials.

12. Method for fabricating a memory cell having a storage capacitor, which is designed as a trench capacitor, and a select transistor, comprising the steps of:
- carrying out the method according to Claim 10 or 11; and
- forming the select transistor with source electrode, drain electrode (17, 56), conductive channel and gate electrode (18, 57), with the upper capacitor electrode (13, 48) being electrically conductively connected to the source or drain electrode (17, 56) of the select transistor.

13. Method according to Claim 12, **characterized in that** the substrate (1, 41) is a silicon substrate or a silicon substrate arranged on an insulator.

14. Method according to one of Claims 10 to 13, **characterized in that** the step of selective formation of metal silicide on the uncovered silicon regions comprises the steps of
- depositing a metal (12, 50) which is suitable for forming a metal-silicon compound with the uncovered silicon in a subsequent heat treatment step,
- heat treatment at a predetermined temperature in a predetermined atmosphere, and
- selective removal of the metal which has not been converted into silicide.

15. Method according to Claim 14, **characterized in that** the heat treatment step is carried out at a temperature of 600 to 1000°C in a nitrogen atmosphere.

16. Method according to Claim 14 or 15, **characterized in that** the duration of the heat treatment step is set in such a manner that only a part of the metal layer which faces the silicon regions forms a metal-silicon compound.

17. Method according to Claim 1, **characterized in that** the metal is selected from tungsten, titanium, molybdenum, tantalum, cobalt, nickel, niobium, platinum, palladium and the rare earths.

18. Method according to one of the preceding claims, **characterized in that** after the step of producing uncovered silicon regions, measures which increase the surface area are carried out on these regions.

## Revendications

1. Procédé de production d'un condensateur de mémoire ayant une structure verticale par rapport à une surface principale d'un substrat à utiliser, notamment dans une cellule de mémoire DRAM, dans lequel on forme une électrode (13, 48, 67) métallique inférieure de condensateur, un diélectrique (14, 51, 68) de mémoire et une électrode (15, 52, 69) supérieure de condensateur dans ou sur la surface principale du substrat, l'électrode (13, 48, 67) métallique inférieure de condensateur étant formée en étant auto-alignée sur un matériau (1, 41, 66) de base en silicium, en ce que l'on produit d'abord des zones de silicium dénudées aux endroits où il faut former l'électrode inférieure de condensateur et on forme ensuite sélectivement du siliciure de métal sur les zones de silicium dénudées,
**caractérisé en ce que** le stade de formation sélective de siliciure de métal (13, 48, 67) sur les zones de silicium dénudées comprend le stade de dépôt sélectif en phase gazeuse du siliciure de métal sur les zones (1, 41, 61) de silicium dénudées.

2. Procédé de production d'un condensateur à sillon à utiliser notamment dans une cellule de mémoire DRAM comprenant les stades dans lesquels :
- on ménage par attaque un sillon (5, 45) dans une surface (2, 42) principale d'un substrat (1, 41) semi-conducteur ;
- on effectue le procédé suivant la revendication 1, le condensateur de mémoire étant disposé au moins en partie dans le sillon (5, 45) et l'électrode (13, 48) inférieure métallique du condensateur étant voisine d'une paroi du sillon ; et
- on met en place un diélectrique (14, 51) de mémoire et une électrode (15, 52) supérieure de condensateur.

3. Procédé suivant l'une des revendications précédentes, **caractérisé en ce que** le stade de formation de zones (1, 41) de silicium dénudées comprend le dépôt d'un matériau (9, 49) de revêtement sur un matériau de base en silicium.

4. Procédé suivant la revendication 3, **caractérisé en ce que** le matériau (9, 49) de revêtement est choisi en nitrure de silicium ou en dioxyde de silicium ou en une combinaison de ces matériaux.

5. Procédé de production d'une cellule de mémoire ayant un condensateur de mémoire qui est réalisé en condensateur à sillon et un transistor de sélection comprenant les stades dans lesquels :
- on ménage par attaque un sillon (5, 45) dans une surface (2, 42) principale d'un substrat (1, 41) en silicium ;
- on effectue le procédé suivant la revendication 3 ou 4, le condensateur de mémoire étant disposé au moins en partie dans le sillon (5, 45) et l'électrode (13, 48) métallique inférieure du condensateur étant voisine d'une paroi du sillon ; et
- on forme le transistor de sélection ayant une électrode de source, une électrode (17, 56) de drain, un canal conducteur et une électrode (18, 57) de grille, l'électrode (13, 48) supérieure de condensateur étant reliée d'une manière conductrice de l'électricité à l'électrode (17, 56) de source ou de drain du transistor de sélection.

6. Procédé suivant la revendication 5, **caractérisé en ce que** le substrat (1, 41) est un substrat en silicium ou est un substrat en silicium disposé sur un isolateur.

7. Procédé de production d'un condensateur empilé à utiliser notamment dans une cellule de mémoire DRAM comprenant les stades dans lesquels :
- on dépose de manière structurée une couche (66) de polysilicium qui est propre à être utilisée comme structure de liaison conductrice de l'électricité entre une électrode inférieure de condensateur et une électrode de source ou de drain d'un transistor de sélection de la cellule de mémoire DRAM sur un matériau qui n'est pas du silicium ;
- on effectue le procédé suivant la revendication 1 pour la formation auto-alignée de l'électrode (67) métallique inférieure du condensateur ; et
- on met en place un diélectrique (68) de mémoire et une électrode (69) supérieure de condensateur.

8. Procédé suivant la revendication 1, **caractérisé en ce que** le stade de formation de zones de silicium dénudées comprend le dépôt structuré d'une couche (66) de silicium ou de polysilicium sur un matériau qui n'est pas du silicium.

9. Procédé de production d'une cellule de mémoire ayant un condensateur de mémoire qui est réalisé en condensateur empilé et un transistor de sélection comprenant
- le stade de formation d'un transistor de sélection ayant une électrode de source, une électrode (64) de drain, un canal conducteur et une électrode (65) de grille sur une surface (62) principale d'un substrat (61) semi-conducteur,
- les stades du procédé suivant la revendication 8 de manière à former sur la surface qui se produit l'électrode (67) inférieure du condensateur sur une structure (66) de liaison conductrice de l'électricité en polysilicium qui relie l'électrode (67) inférieure du condensateur à l'électrode (64) de source ou de drain du transistor de sélection.

10. Procédé de production d'un condensateur à sillon à utiliser notamment dans une cellule de mémoire DRAM comprenant les stades dans lesquels :
- on ménage par attaque un sillon (5, 45) dans une surface (2, 42) principale d'un substrat (1, 41) en silicium ;
- on produit des zones de silicium dénudées par dépôt d'un matériau (9, 49) de revêtement sur les zones de sillon sur lesquelles il ne faut pas former l'électrode inférieure de condensateur ;
- on forme de façon auto-alignée une électrode (13, 48) inférieure métallique de condensateur en siliciure de métal par dépôt sélectif d'un métal en phase gazeuse sur les zones de silicium dénudées, le condensateur de la mémoire étant disposé au moins en partie dans le sillon (5, 45) et l'électrode (13, 48) inférieure métallique du condensateur étant voisine d'une paroi du sillon ;
- on forme ensuite un diélectrique (14, 51) de mémoire ; et
- on forme ensuite une électrode (15, 52) supérieure de condensateur.

11. Procédé suivant la revendication 10, **caractérisé en ce que** l'on choisit le matériau (9, 49) de revêtement en nitrure de silicium ou en dioxyde de silicium ou en une combinaison de ces matériaux.

12. Procédé de production d'une cellule de mémoire ayant un condensateur de mémoire qui est réalisé en condensateur à sillon et un transistor de sélection comprenant les stades dans lesquels :
- on effectue le procédé suivant la revendication 10 ou 11 ; et
- on forme le transistor de sélection ayant une électrode de source, une électrode (17, 56) de drain, un canal conducteur et une électrode (18, 57) de grille, l'électrode (13, 48) supérieure de condensateur étant reliée d'une manière conductrice de l'électricité à l'électrode (17, 56) de source ou de drain du transistor de sélection.

13. Procédé suivant la revendication 12, **caractérisé en ce que** le substrat (1, 41) est un substrat en silicium ou est un substrat en silicium disposé sur un isolateur.

14. Procédé suivant l'une des revendications 10 à 13, **caractérisé en ce que** le stade de formation sélective de siliciure de métal sur les zones de silicium dénudées comprend les stades dans lesquels :
- on dépose un métal (12, 50) qui est propre à entrer, dans un stade ultérieur de traitement thermique, dans une liaison métal-silicium avec le silicium dénudé ;
- on traite thermiquement à une température prescrite dans une atmosphère prescrite ; et
- on élimine sélectivement le métal non transformé en siliciure.

15. Procédé suivant la revendication 14, **caractérisé en ce que** l'on effectue le stade de traitement thermique à une température de 600 à 1 000°C dans une atmosphère d'azote.

16. Procédé suivant la revendication 14 ou 15, **caractérisé en ce que** l'on règle la durée du stade du traitement thermique de façon à ce que seule une partie, tournée vers les zones du silicium, de la couche métallique entre dans une liaison métal-silicium.

17. Procédé suivant la revendication 1, **caractérisé en ce que** le métal est choisi parmi le tungstène, le titane, le molybdène, le tantale, le cobalt, le nickel, le niobium, le platine, le palladium et les métaux de terres rares.

18. Procédé suivant l'une des revendications précédentes, **caractérisé en ce qu'**après le stade de production des zones de silicium dénudées, on prend des mesures d'agrandissement de la surface sur ces zones.
